(19) Europäisches Patentamt
European Patent Office
Office européen des brevets

(11) **EP 4 757 509 A2**

(12) **EUROPÄISCHE PATENTANMELDUNG**

(43) Veröffentlichungstag:
**10.06.2026 Patentblatt 2026/24**

(21) Anmeldenummer: **26168312.2**

(22) Anmeldetag: **28.04.2021**

(51) Internationale Patentklassifikation (IPC):
*H05K 3/38* (2006.01)   *H10W 40/25* (2026.01)
*B32B 7/12* (2006.01)   *B32B 9/00* (2006.01)
*B32B 9/04* (2006.01)   *B32B 17/06* (2006.01)
*B32B 15/04* (2006.01)   *B32B 15/08* (2006.01)
*C04B 37/02* (2006.01)   *H05K 1/03* (2006.01)
*H10W 70/692* (2026.01)

(52) Gemeinsame Patentklassifikation (CPC):
**H05K 3/388; B32B 7/12; B32B 9/005; B32B 9/041; B32B 15/04; B32B 15/08; B32B 17/061; C04B 37/025; C04B 37/026; H10W 40/255;** B32B 2250/40; B32B 2307/206; B32B 2457/04; C04B 2235/963; C04B 2237/06;   (Forts.)

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **29.04.2020   DE 102020111700**

(62) Dokumentnummer(n) der früheren Anmeldung(en) nach Art. 76 EPÜ:
**21722431.0 / 4 115 715**

(71) Anmelder: **Rogers Germany GmbH**
**92676 Eschenbach (DE)**

(72) Erfinder:
• **Schmidt, Karsten**
**92676 Eschenbach (DE)**

• **Welker, Tilo**
**91284 Neuhaus (DE)**
• **Britting, Stefan**
**91220 Schnaittach (DE)**

(74) Vertreter: **Müller Schupfner & Partner Patent- und Rechtsanwaltspartnerschaft mbB (Muc)**
**Bavariaring 11**
**80336 München (DE)**

Bemerkungen:
Diese Anmeldung ist am 27.03.2026 als Teilanmeldung zu der unter INID-Code 62 erwähnten Anmeldung eingereicht worden.

(54) **VERFAHREN ZUR HERSTELLUNG EINES TRÄGERSUBSTRATS UND EIN TRÄGERSUBSTRAT**

(57)     Trägersubstrat (1), insbesondere ein Metall-Keramik-Substrat, als Träger für elektrische Bauteile, umfassend:
- mindestens eine Metallschicht (10) und
- ein Isolationselement (30), insbesondere ein Keramikelement, ein Glaselement, ein Glaskeramikelement und/oder ein hochtemperaturbeständiges Kunststoffelement, wobei sich die mindestens eine Metallschicht (10) und das Isolationselement (30) entlang einer Haupterstreckungsebene (HSE) erstrecken und entlang einer senkrecht zur Haupterstreckungsebene (HSE) verlaufenden Stapelrichtung (S) übereinander angeordnet sind, wobei im gefertigten Trägersubstrat (1) eine Bindungsschicht (12) zwischen der mindestens einen Metallschicht (10) und dem Isolationselement (30) ausgebildet ist, und wobei eine Haftvermittlerschicht (13) der Bindungsschicht (12) einen Flächenwiderstand aufweist der größer ist als 5 Ohm/sq, bevorzugt größer als 10 Ohm/sq und besonders bevorzugt größer als 20 Ohm/sq annimmt.

FIG. 5

(52) Gemeinsame Patentklassifikation (CPC): (Forts.)
C04B 2237/068; C04B 2237/125; C04B 2237/127;
C04B 2237/708; C04B 2237/72; H05K 1/0306;
H05K 2201/2063; H10W 70/692

**Beschreibung**

Die vorliegende Erfindung betrifft ein Verfahren zur Herstellung eines Trägersubstrats und ein Trägersubstrat.

Trägersubstrate, wie z. B. Metall-Keramik-Substrate, sind als Leiterplatten oder Platinen aus dem Stand der Technik hinlänglich bekannt, beispielsweise aus der DE 10 2013 104 739 A1, der DE 19 927 046 B4 und der DE 10 2009 033 029 A1. Typischerweise werden auf einer Bauteilseite des Metall-Keramik-Substrats bzw. des Trägersubstrats Anschlussflächen für elektrische Bauteile und Leiterbahnen angeordnet, wobei die elektrischen Bauteile und die Leiterbahnen zu elektrischen Schaltkreisen zusammenschaltbar sind. Wesentliche Bestandteile der Metall-Keramik-Substrate sind eine Isolationsschicht, die bevorzugt aus einer Keramik gefertigt ist, und wenigstens eine an die Isolationsschicht angebundene Metallschicht. Wegen ihrer vergleichsweise hohen Isolationsfestigkeiten haben sich aus Keramik gefertigte Isolationsschichten in der Leistungselektronik als besonders vorteilhaft erwiesen. Durch eine Strukturierung der Metallschicht können sodann Leiterbahnen und/oder Anschlussflächen für die elektrischen Bauteile realisiert werden.

Voraussetzung für das erfolgreiche Bereitstellen eines Metall-Keramik-Substrats ist eine dauerhafte Anbindung der Metallschicht an die Keramikschicht. Neben einem sogenannten Direktmetallanbindungsverfahren, d. h. einem DCB- oder DAB-Verfahren, ist es aus dem Stand der Technik bekannt, die Metallschicht über ein Lotmaterial an die Keramikschicht anzubinden (AMB Verfahren).

Unter einem Aktivlotverfahren, z. B. zum Verbinden von Metallschichten oder Metallfolien, insbesondere auch von Kupferschichten oder Kupferfolien, mit Keramikmaterial, ist hier ein Verfahren zu verstehen, welches speziell zum Herstellen von Metall-Keramik-Substraten verwendet wird. Dabei wird bei einer Temperatur zwischen ca. 650-1000°C eine Verbindung zwischen einer Metallfolie, beispielsweise einer Kupferfolie, und einem Keramiksubstrat, beispielsweise einer Aluminiumnitrid-Keramik, unter Verwendung eines Hartlots hergestellt, welches zusätzlich zu einer Hauptkomponente wie Kupfer, Silber und/oder Gold auch ein Aktivmetall enthält. Dieses Aktivmetall, welches beispielsweise wenigstens ein Element aus der Gruppe Hf, Ti, Zr, Nb, Ce ist, stellt durch chemische Reaktion eine Verbindung zwischen dem Lot und der Keramik her, während die Verbindung zwischen dem Lot und dem Metall eine metallische Hartlot-Verbindung ist.

Ferner ist beispielsweise aus der DE 10 2013 113 734 B4, sowie aus der JP 4 - 325 470, ein Verfahren bekannt, bei dem mittels heißisostatischem Pressen eine Anbindung einer Metallschicht an eine Keramikschicht zwecks der Ausbildung eines Metall-Keramik-Substrats vollzogen wird. Das heißisostatische Pressen wird darüber hinaus auch zur Nachbehandlung verwendet, um eine Anzahl an gebildeten Lunkern, die während der Anbindung mit einem Lotverfahren oder mit einem Direktmetallanbindungsverfahren entstehen, zu reduzieren.

Ausgehend vom Stand der Technik macht es sich die vorliegende Erfindung zur Aufgabe, ein Trägersubstrat, insbesondere ein Metall-Keramik-Substrat, bereitzustellen, das gegenüber den bekannten Trägersubstraten weiter verbessert ist, insbesondere in Hinblick auf ein Anbindungsverhalten des Metalls an ein Isolationselement, beispielswiese an ein Keramikelement.

Die vorliegende Erfindung löst diese Aufgabe mit einem Verfahren zur Herstellung eines Trägersubstrats gemäß Anspruch 1 und einem Trägersubstrat gemäß Anspruch 15. Weitere Ausführungsformen sind den abhängigen Ansprüchen und der Beschreibung zu entnehmen.

Gemäß einem ersten Aspekt der vorliegenden Erfindung ist ein Trägersubstrat, insbesondere ein Metall-Keramik-Substrat, als Träger für elektrische Bauteile, vorgesehen, umfassend:

- mindestens eine Metallschicht und
- ein Isolationselement, insbesondere ein Keramikelement, ein Glaselement, ein Glaskeramikelement und/oder ein hochtemperaturbeständiges Kunststoffelement, wobei sich die mindestens eine Metallschicht und das Isolationselement entlang einer Haupterstreckungsebene erstrecken und entlang einer senkrecht zur Haupterstreckungsebene verlaufenden Stapelrichtung übereinander angeordnet sind, wobei im gefertigten Trägersubstrat eine Bindungsschicht zwischen der mindestens einen Metallschicht und dem Isolationselement ausgebildet ist, wobei eine Haftvermittlerschicht der Bindungsschicht einen Flächenwiderstand aufweist, der größer als 5 Ohm/sq, bevorzugt größer als 10 Ohm/sq und besonders bevorzugt größer als 20 Ohm/sq ist.

Gegenüber den aus dem Stand der Technik bekannten Trägersubstraten ist es erfindungsgemäß vorgesehen, dass der Flächenwiderstand einer Haftvermittlerschicht der Bindungsschicht größer ist als 5 Ohm/sq, bevorzugt größer als 10 Ohm/sq und besonders bevorzugt größer als 20 Ohm/sq ist. Der ermittelte Flächenwiderstand steht dabei im direkten Zusammenhang mit einem Anteil des Aktivmetalls in der Haftvermittlerschicht, die maßgeblich für die Anbindung der mindestens einen Metallschicht an das Isolationselement ist. Dabei nimmt der Flächenwiderstand mit abnehmenden Aktivmetallanteil in der Bindungsschicht zu. Ein entsprechend hoher Flächenwiderstand entspricht somit einem geringen Aktivmetallanteil in der Haftvermittlerschicht.

Dabei hängt der Flächenwiderstand nicht von einem einzelnen Parameter ab, sondern kann durch ein Zusammenspiel mehrerer Parameter beeinflusst werden. So trägt beispielsweise auch eine Reinheit des Aktivmetalls, eine Dicke der Bindungsschicht und/oder eine Oberflächenrauigkeit des Isolationselements zur Festlegung des Flächenwiderstandes bei. Insbesondere lassen sich hohe Flächenwiderstände nur durch ein Zusammenspiel von mindestens zwei Parametern realisieren.

Es hat sich dabei herausgestellt, dass mit zunehmenden Anteil an Aktivmetall die Bildung von spröden, intermetallischen Phasen begünstigt wird, was wiederum nachteilig ist für eine Abzugsfestigkeit der Metallschicht an der Isolationsschicht. Mit anderen Worten: Mit den anspruchsgemäßen Flächenwiderständen werden solche Bindungsschichten beschrieben, deren Abzugsfestigkeit aufgrund der reduzierten Bildung von spröden intermetallischen Phasen, verbessert, d. h. vergrößert wird. Durch das gezielte Einstellen der anspruchsgemäßen Flächenwiderstände lassen sich somit besonders starke Anbindungen der mindestens einen Metallschicht an das Keramikelement realisieren. Eine solche erhöhte Anbindungsstärke wirkt sich in vorteilhafter Weise auf die Lebensdauer des Trägersubstrats aus.

Dabei ist es zur Bestimmung des Flächenwiderstands vorgesehen, dass am gefertigten Trägersubstrat zunächst die Metallschicht und ggf. eine Lotbasisschicht, beispielsweise durch Ätzen, wieder entfernt werden. Mittels einer Vier-Punkt Messung wird dann an der Oberseite bzw. Unterseite des von der mindestens einen Metallschicht und der Lotbasisschicht befreiten Trägersubstrats ein Flächenwiderstand gemessen. Insbesondere ist unter dem Flächenwiderstand einer Materialprobe als dessen Widerstand bezogen auf einen quadratischen Oberflächenbereich zu verstehen. Es ist hierbei üblich den Oberflächenwiderstand mit der Einheit Ohm/sq(square) zu kennzeichnen. Die Physikalische Einheit des Flächenwiderstandes ist Ohm.

Vorzugsweise ist es vorgesehen, dass eine in Stapelrichtung bemessene Dicke der Bindungsschicht, gemittelt über mehrere Messpunkte innerhalb einer vorbestimmten Fläche oder in mehreren Flächen, die parallel zur Haupterstreckungsebene verläuft oder verlaufen, einen Wert annimmt, der kleiner als 0,20 mm, bevorzugt kleiner als 10 $\mu$m und besonders bevorzugt kleiner als 6 $\mu$m ist. Sofern vom mehreren Flächen gesprochen wird, ist insbesondere gemeint, dass die mindestens eine Metallschicht in möglichst gleich große Flächen unterteilt wird und in jeder dieser die mindestens eine Metallschicht unterteilenden Flächen mindestens ein Wert, bevorzugt mehrere Messwerte, für die Dicke erfasst werden. Die so an verschiedenen Stellen ermittelten Dicken werden arithmetisch gemittelt.

Gegenüber den aus dem Stand der Technik bekannten Trägersubstraten ist somit eine vergleichsweise dünne Bindungsschicht zwischen der mindestens einen Metallschicht und dem Isolationselement ausgebildet. Dabei ist es vorgesehen, dass zur Festlegung der maßgeblichen Dicke der Bindungsschicht die gemessenen Dicken über eine Vielzahl von Messpunkten gemittelt werden, die innerhalb einer vorbestimmten bzw. festgelegten Fläche bzw. den mehreren Flächen liegen. Dadurch wird in vorteilhafter Weise mitberücksichtigt, dass das Isolationselement, insbesondere das Keramikelement, in der Regel einer Ondulation unterworfen ist, d. h. dem Isolationselement ist eine Welligkeit zuzusprechen. Insbesondere versteht der Fachmann unter einer Welligkeit eine Modulation des generellen flachen Verlaufs des Isolationselements, gesehen über mehrere Millimeter oder Zentimeter entlang einer Richtung, die parallel zur Haupterstreckungsebene verläuft. Damit grenzt sich eine derartige Ondulation von einer Oberflächenrauigkeit des Isolationselements ab, die in der Regel zusätzlich am Isolationselement vorliegt. Durch das Einbeziehen einer derartigen, in der Regel unvermeidbaren Ondulation des Isolationselements in die Bestimmung der Dicke wird berücksichtigt, dass die Bindungsschicht aufgrund der Ondulation gegebenenfalls variieren kann, insbesondere in Talbereichen des Isolationselements größer sein kann als in Bergbereichen des Isolationselements.

Ungeachtet dieser Ondulation ist der gemittelte Dickenwert dennoch deutlich geringer als derjenige, der in Trägersubstraten aus dem Stand der Technik bekannt ist. Dies wird insbesondere bzw. beispielsweise dadurch erzielt, dass eine benötigte Aktivmetallschicht zwischen dem Isolationselement und der mindestens einen Metallschicht angeordnet wird, die insbesondere einzeln, also separat, zwischen dem Isolationselement und der mindestens einen Metallschicht angeordnet ist, beispielsweise zusätzlich zu einem Lotbasismaterial (das beispielsweise kein Aktivmetall enthält bzw. aktivmetallfrei ist). Vorzugsweise wird das Aktivmetall mittels eines chemischen und/oder physikalischen Gasphasenabscheidens, beispielsweise mittels eines Sputterns, auf dem Lotbasismaterial und/oder der mindestens einen Metallschicht und/oder dem Isolationselement aufgetragen, um vergleichsweise dünne Aktivmetallschichten zu realisieren, die wiederrum zu einer vergleichsweise dünnen Bindungsschicht führen, insbesondere zu einer homogenen und dünnen Haftvermittlerschicht. Vorstellbar ist es auch unter Verwendung eines Plasmas, in einem Vakuum und/oder mittels Aufdampfen die Aktivmetallschicht auf dem Lotbasismaterial, dem Isolationselement und/oder der mindestens einen Metallschicht bereitzustellen. Denkbar ist auch, die Aktivmetallschicht galvanisch zu realisieren. Besonders bevorzugt ist es vorgesehen, dass die Aktivmetallschicht und/oder das Lotbasismaterial als Folie bereitgestellt wird.

Vorzugsweise ist ein Anteil an Aktivmetall in der ein Aktivmetall umfassenden Haftvermittlerschicht größer ist als 15 Gew.- %, bevorzugt größer als 20 Gew.- % und besonders bevorzugt größer als 25 Gew.- %.

Weiterhin ist es vorstellbar, dass das Lotbasismaterial und/oder die Aktivmetallschicht Aussparungen aufweist. In einem solchen Fall ist es möglich, eine dickere Schicht für das Lotbasismaterial und/oder die Aktivmetallschicht zu nutzen, da während des Anbindungsprozesses das Lotbasismaterial und/oder die Aktivmetallschicht verflüssigt und die vorherigen Aussparungen bzw. Bereich der Aussparungen verfüllt. Dadurch kann in gleicher Weise ein erstrebenswerter, vergleichsweise geringer Anteil an Aktivmetall für das Bilden der Haftvermittlerschicht bereitgestellt werden, auch wenn beispielsweise eine größere Dicke der Aktivmetallschicht zugeordnet ist. Beispielsweise handelt es sich bei dem Lotbasismaterial und/oder der Aktivmetallschichtmit Aussparung um ein Gitter oder Streckmetall, das beispielsweise aus einem maschen- oder zaunartigen Geflecht geformt ist und zwischen dem Isolationselement und der mindestens einen Metallschicht angeordnet wird. Dabei werden Lotbasismaterial und/oder Aktivmetallschicht bevorzugt als Folien bereitgestellt.

Die Ausbildung von vergleichsweise dünnen Bindungsschichten reduziert insbesondere einen Aufwand, der aufgebracht werden muss, um beispielsweise in einem "second etching", zumindest bereichsweise, die Bindungsschicht wieder zu entfernen, um das Trägersubstrat, insbesondere dessen mindestens eine Metallschicht und die Bindungsschicht, zu strukturieren. Vorzugsweise erfolgt dieses Strukturieren, das dazu dient, mehrere Metallabschnitte der mindestens einen Metallschicht voneinander elektrisch zu isolieren, durch ein Ätzen und/oder ein mechanischen Bearbeitungsschritt und/oder mit Laserlicht. Außerdem hat es sich als vorteilhaft erwiesen, dass durch die Verwendung geringer Schichtdicken die Anzahl der möglichen Fehler in der Bindungsschicht, beispielsweise hervorgerufen durch Materialfehler im Lotmaterial, in vorteilhafter Weise reduziert werden kann. Unter einem Fehler in der Bindungsschicht bzw. einem Materialfehler im Lotmaterial wird beispielsweise ein großes Korn im Lotmaterial, wie beispielswiese ein Aktivmetallkorn, verstanden, das zur Riesenbildung einer Körnung in der Bindungsschicht führen kann, und/oder das nicht vollständig aufschmilzt und damit als Abstandshalter minimale Lotspalte verhindert. Durch das Auftragen, insbesondere mittels Sputtern, kann in einfacher Weise verhindert werden, dass vergleichsweise große Körner Bestandteil der Aktivmetallschicht werden, die auch noch in der Bindungsschicht bzw. der Haftvermittlerschicht zu erkennen sind. Schließlich ist es von Vorteil, dass sich homogen über das hergestellte Trägersubstrat eine dünne Bindungsschicht ausbildet.

Insbesondere ist unter der gemittelten Dicke der Bindungsschicht zu verstehen, dass in einer festgelegten Fläche oder mehreren Flächen jeweils stochastisch oder statistisch verteilt Dicken ermittelt bzw. gemessen werden und anschließend deren arithmetisches Mittel bestimmt wird. Hierzu werden beispielsweise zunächst einmal mehrere mikroskopische Aufnahmen von verschiedenen Schnittbildern herangezogen, vorzugsweise unter Verwendung eines Rasterelektronenmikroskop (REM), wobei sich die Schnittbilder jeweils durch das Trägersubstrat in einer senkrecht zur Haupterstreckungsebene verlaufenden Richtung erstrecken. Dabei verlaufen die Schnittbilder entlang einer Schnittebene, die senkrecht zur Haupterstreckungsebene verläuft. Die Dicken werden dann in der Schnittebene bestimmt. Mit anderen Worten: es werden mehrere Schnittbilder aufgenommen, die jeweils senkrecht zur Haupterstreckungsebene verlaufen und gleichmäßig oder unregelmäßig an Messpunkten innerhalb der Fläche oder in mehreren verschiedenen Flächen verteilt sind. Beispielsweise werden mehrere parallel zueinander versetzte Schnittbilder herangezogen, indem z.B. scheibenweise Schnitte vom Trägersubstrat abgetragen werden. Anschließend werden vorzugsweise mehr als 25 oder 100 Dicken, bevorzugt mehr als 200 und besonders bevorzugt mehr als 500 Dicken der Bindungsschicht in der festgelegten Fläche auf dem Substrat gemessen, d. h. in den verschiedenen Schnittbildern, ermittelt und das arithmetische Mittel bestimmt. Der Abstand zwischen zwei Messpunkten ist dabei mindestens 100 $\mu$m, um den Einfluss der Ondulation auf das Messergebnis zu verringern. Da in einem Trägersubstrat in der Regel zwei Bindungsschichten sich zu beiden Seiten der Keramik gegenüberliegen, sind die genannten Messwerte der Schichtdicke auf der gegenüberliegenden Seite auch in derselben Anzahl zu messen. Umso größer die Fläche gewählt wird, umso geringer ist die Wahrscheinlichkeit, dass durch die Ondulation ein irrtümliches bzw. verzerrtes Bild der ermittelten Dicken in der Bindungsschicht erfasst wird. Die vorbestimmte bzw. festgelegte Fläche, die insbesondere parallel zur Haupterstreckungsebene verläuft, hat dabei für Großkarte eine Größe von mehr als 25 cm$^2$, bevorzugt mehr als 50 cm$^2$, besonders bevorzugt mehr als 100 cm$^2$. Für ein aus der Großkarte vereinzeltes Trägersubstrat kann die Größe mehr als 1 cm$^2$, bevorzugt mehr als 1,5 cm$^2$ und besonders bevorzugt mehr als 5 cm$^2$ sein.

Besonders bevorzugt ist folgendes Verfahren zur Bestimmung und Auswahl der zur Bestimmung beitragenden Messbereiche - unabhängig von der Größe des Trägersubstrats - vorgesehen:
In einem ersten Schritt wird die mindestens eine Metallschicht des Trägersubstrats in neun gleich große Rechtecke, insbesondere Quadrate, d. h. in mehrere etwa gleich große Flächen, unterteilt. In den so festgelegten Messbereichen werden jeweils zwei oder drei Schnittbilder erzeugt, die herangezogen werden, um in jedem der Schnittbilder eine gemittelte Dicke für die mindestens eine Metallschicht zu bestimmen. Die Schnittbilder werden bevorzugt mittels eines REM-Verfahrens aufgenommen, beispielsweise in einer 2000 oder 2500- fachen Vergrößerung. Anschließend wird in einem zweiten Schritt über die insgesamt 18 oder 27 in den Schnittbildern erfassten Dicken, die über alle neun rechteckigen Messbereiche verteilt sind, gemittelt. Auf diese Weise wird in vorteilhafter Weise sichergestellt, dass die gemittelte Dicke einen repräsentativen Wert für die Bindungsschicht zwischen der mindestens einen Metallschicht und dem Isolationselement für das gesamte Trägersubstrat darstellt. Mit anderen Worten: die in dem Abschnitt beschriebene Vorgehensweise sieht gemittelte Dicke vor, die über die mindestens eine Metallschicht gesehen in gleichmäßig verteilten Messbereichen bestimmt ist. Das hier beschriebene Verfahren zur Auswahl der Messbereich, die zur Bestimmung eines gemittelten Werts für die Dicke beiträgt ist analog für die Bestimmung des Flächenwiderstands heranzuziehen.

Vorzugsweise ist das Trägersubstrat als Leiterplatte vorgesehen, bei der im gefertigten Zustand die mindestens eine Metallschicht, die an das Isolationselement angebunden ist, strukturiert ist. Beispielsweise ist es hierzu vorgesehen, dass nach dem Anbindungsschritt auch eine Strukturierung, beispielsweise durch Lasern, Ätzen und/oder eine mechanische Bearbeitung, vorgenommen wird, mit der Leiterbahnen und/oder Anschlüsse für elektrische oder elektronische Bauteile realisiert werden. Vorzugsweise ist es vorgesehen, dass an einem gefertigten Metall-Keramik-Substrat an dem Keramikelement, an dem der Metallschicht gegenüberliegenden Seite, eine weitere Metallschicht, insbesondere eine Rückseitenmetallisierung und/oder ein Kühlelement vorgesehen ist. Dabei dient die Rückseitenmetallisierung vorzugsweise dazu, einer Durchbiegung entgegenzuwirken und das Kühlelement dient einem wirkungsvollen Abführen von Wärme, die im Betrieb von elektrischen bzw. elektronischen Bauteilen ausgeht, die an die Leiterplatte, bzw. das Metall-Keramik-Substrat angebunden sind.

Als Materialien für die mindestens eine Metallschicht und/oder die mindestens eine weitere Metallschicht im Metall-Keramik-Substrat bzw. Isolationselement sind Kupfer, Aluminium, Molybdän, Wolfram, Nickel und/oder deren Legierungen wie z. B. CuZr, AlSi oder AlMgSi, sowie Laminate wie CuW, CuMo, CuAl und/oder AlCu oder MMC (metal matrix composite), wie CuW, CuM oder AlSiC, vorstellbar. Weiterhin ist bevorzugt vorgesehen, dass die mindestens eine Metallschicht am gefertigten Metall-Keramik-Substrat, insbesondere als Bauteilmetallisierung, oberflächenmodifiziert ist. Als Oberflächenmodifikation ist beispielsweise eine Versiegelung mit einem Edelmetall, insbesondere Silber; und/oder Gold, oder (electroless) Nickel oder ENIG ("*electroless nickel immersion gold*") oder ein Kantenverguss an der Metallisierung zur Unterdrückung einer Rissbildung bzw. -weitung denkbar.

Vorzugsweise weist das Keramikelement $Al_2O_3$, $Si_3N_4$, AIN, eine HPSX-Keramik (d. h. eine Keramik mit einer $Al_2O_3$- Matrix, die einen x-prozentigen Anteil an $ZrO_2$ umfasst, beispielsweise $Al_2O_3$ mit 9% $ZrO_2$ = HPS9 oder $Al_2O_3$ mit 25% $ZrO_2$ = HPS25), SiC, BeO, MgO, hochdichtes MgO (> 90% der theoretischen Dichte), TSZ (tetragonal stabilisiertes Zirkonoxid) als Material für die Keramik auf. Es ist dabei auch vorstellbar, dass das Keramikelement als Verbund- bzw. Hybridkeramik ausgebildet ist, bei der zur Kombination verschiedener gewünschter Eigenschaften mehrere Keramikschichten, die sich jeweils in Hinblick auf ihre materielle Zusammensetzung unterscheiden, übereinander angeordnet und zu einem Isolationselement zusammengefügt sind.

Vorzugsweise ist die Bindungsschicht flächig, insbesondere ohne Unterbrechung, d. h. durchgehend, zwischen der mindestens einen Metallschicht und dem Keramikelement ausgebildet. Vorzugsweise ist es vorgesehen, dass ein Verhältnis eines Bereichs, in dem zwischen der mindestens einen Metallschicht und dem Isolationselement keine Bindungsschicht ausgebildet ist zu den Bereichen, in denen zwischen der mindestens einen Bindungsschicht und dem Isolationselement eine Bindungsschicht ausgebildet ist kleiner als 0,05 mm, bevorzugt kleiner als 0,02 mm und besonders bevorzugt kleiner als 0,007 mm. Dabei versteht der Fachmann insbesondere, dass zur Bildung dieses Verhältnisses die Bereiche nicht berücksichtigt werden, die aufgrund der Strukturierung frei sind von Metall der mindestens einen Metallschicht.

Vorzugsweise ist es vorgesehen, dass das Trägersubstrat mindestens eine weitere Metallschicht umfasst, die an dem Isolationselement an einer der mindestens einen Metallschicht gegenüberliegenden Seite angebunden ist, wobei im gefertigten Trägersubstrat eine weitere Bindungsschicht zwischen der mindestens einen weiteren Metallschicht und dem Isolationselement ausgebildet ist, wobei auch hier eine in Stapelrichtung bemessene aufsummierte Dicke der Bindungsschicht und der weiteren Bindungsschicht, gemittelt über mehrere Messpunkte innerhalb einer vorbestimmten Fläche oder mehrere Flächen, die parallel zur Haupterstreckungsebene verläuft bzw. verlaufen, einen Wert annimmt, der kleiner ist als 0,045 mm, bevorzugt kleiner als 0,0225 mm und besonders bevorzugt kleiner als 0,0135mm .

Vorzugsweise ist es vorgesehen, dass die Bindungsschicht und/oder die weitere Bindungsschicht Silber aus einem Lotmaterial und/oder einem Lotbasismaterial aufweist. Im Allgemeinen bildet diese Schicht eine Lotbasisschicht aus, in der sich der Hauptbestandteil des Lotbasismaterials im gefertigten Trägersubstrat sammelt. Beispielsweise wird als Bindungsschicht diejenige Schicht verstanden, die sich im Falle eines silberbasierten Lotmaterials zwischen der mindestens einen Metallschicht und dem Isolationselement ausbildet. Diese umfasst im Wesentlichen Silber und lässt sich entsprechend in einem Schnittbild entlang der Stapelrichtung angefertigten Metall-Keramik-Substrat identifizieren. Dabei bezieht sich die heranzuziehende bzw. zu vermessende Dicke auf den massiven Anteilen an silberreichen Phasen und schließt insbesondere solche Einschlüsse aus, die in der mindestens einen Metallschicht, insbesondere im Randbereich zu der Silberschicht, zu finden sind.

Vorzugsweise ist neben dem Silber, das auf ein silberbasiertes Lotmaterial bzw. auf ein silberbasiertes Lotbasismaterial zurückzuführen ist, in der Bindungsschicht eine Haftvermittlerschicht ausgebildet. Im Falle eines Metall-Keramik-Substrats wird die Haftvermittlerschicht dabei vorzugsweise durch eine Verbindung realisiert bzw. ausgebildet, die zum einen das Aktivmetall, beispielsweise Titan, und zum anderen die Bestandteil des Keramikelements, beispielsweise Sauerstoff O, Stickstoff N und/oder Kohlenstoff C und/oder Silizium Si und/oder Aluminium Al und/oder Magnesium Mg und/oder Calcium Ca umfasst. In entsprechender Weise umfasst die Haftvermittlerschicht beispielsweise Titannitrid, Titancarbid und/oder Titanoxid, insbesondere in verschiedenen Oxidationsstufen.

Weiterhin ist es vorstellbar, dass das Lotbasismaterial als Folie, als Paste, als eine durch physikalisches und/oder chemisches Gasphasenabscheiden entstandene Schicht, und/oder als galvanisch gebildete Schicht bereitgestellt wird.

Vorzugsweise ist es vorgesehen, dass die Bindungsschicht und/oder die weitere Bindungsschicht eine ein Aktivmetall umfassende Haftvermittlerschicht ist. Insbesondere ist es vorgesehen, dass die Bindungsschicht nur aus der Haftvermittlerschicht ausgebildet ist, die das Aktivmetall umfasst. Dabei weist die Haftvermittlerschicht in der Bindungsschicht eine Verbindung mit einem Bestandteil des Keramikelements, wie beispielsweise Stickstoff, Sauerstoff oder Kohlenstoff, und den anderen Bestandteilen der Keramik auf. In entsprechender Weise umfasst die Haftvermittlerschicht beispielsweise Titannitrid, Titanoxid und/oder Titancarbid. Beispielsweise umfasst die Bindungsschicht ausschließlich die das Aktivmetall umfassende Haftvermittlerschicht, d. h. die Bindungsschicht weist kein Silber oder andere Basislotbestandteile auf. In diesem Fall ist es vorgesehen, dass eine in Stapelrichtung gemessene Dicke der Bindungsschicht gemittelt über mehrere Messpunkte innerhalb einer Fläche, die parallel zur Haupterstreckungsebene verläuft, oder der mehreren Flächen einen Wert annimmt der kleiner ist als 0,003 mm (3000 nm) , bevorzugt kleiner als 0,001 mm (1500 nm) und besonders bevorzugt kleiner als 0,0005 mm (500 nm) oder sogar kleiner als 0,00035 mm (350 nm). Insbesondere für solche Bindungsschichten, bei den auf ein Lotbasismaterial und/oder einen Silberanteil verzichtet wird, lässt sich in entsprechender Weise eine noch dünnere Bindungsschicht ausbilden.

Insbesondere ist es vorgesehen, dass die ein Aktivmetall umfassende Haftvermittlerschicht eine im Wesentlichen konstante Dicke aufweist, insbesondere im Gegensatz zu der Lotbasisschicht, die wegen der Ondulation im Isolationselement moduliert ist. Insbesondere weisen die innerhalb der Fläche oder den Flächen bestimmten Messwerte der Dicke eine Verteilung auf, der eine Standardabweichung zuzuordnen ist, die kleiner ist als $0,2\ \mu m$, bevorzugt kleiner als $0,1\ \mu m$ und besonders bevorzugt kleiner als $0,05\ \mu m$. Insbesondere das physikalische und/oder chemische Gasphasenabscheiden einer Aktivmetallschicht und sich die daraus ergebenden Bindungsschicht gestatten es, eine homogene und gleichmäßig verteilte Dicke der Bindungsschicht zu erzielen, die insbesondere nur aus der Haftvermittlerschicht besteht. Die Haftvermittlerschicht kann dabei auch eine konstante Dicke aufweisen, wenn sie zusätzlich zum Lotbasismaterial ausgebildet ist.

Ein weiterer Gegenstand der vorliegenden Erfindung ist ein Verfahren zur Herstellung eines Trägersubstrats, insbesondere eines Metall-Keramik-Substrats, gemäß der vorliegenden Erfindung umfassend:

- Bereitstellen mindestens einer Metallschicht und eines Isolationselements, insbesondere eines Keramikelements, eines Glaselements, einer Glaskeramikelements und/oder eines hochtemperaturbeständigen Kunststoffelements, wobei sich die mindestens eine Metallschicht und das Isolationselement entlang einer Haupterstreckungsebene erstrecken,
- Anordnen der mindestens einen Metallschicht und des Isolationselements in einer senkrecht zur Haupterstreckungsebene verlaufenden Stapelrichtung übereinander, wobei zwischen der mindestens einen Metallschicht und dem Isolationselement eine Aktivmetallschicht angeordnet ist und
- Anbinden der mindestens einen Metallschicht an das Isolationselement über die Aktivmetallschicht unter Ausbildung einer Bindungsschicht zwischen der mindestens einen Metallschicht und dem Isolationselement.

Alle für das Trägersubstrat beschriebenen Vorteile und Eigenschaften lassen sich übertragen bzw. analog übertragen auf das Verfahren und andersrum.

Vorzugsweise ist es vorgesehen, dass die Aktivmetallschicht durch ein chemisches oder elektrochemisches Abscheiden und/oder gasphysikalisches Gasphasenabscheiden (PVD) eines Aktivmetalls realisiert wird. Dabei kann die Aktivmetallschicht auf dem Isolationselement, dem Lotbasismaterial und/oder der mindestens einen Metallschicht ausgebildet werden. Alternative oder ergänzend ist es vorstellbar, dass die Aktivmetallschicht als separate Folie bereitgestellt wird oder als Folie, die im Verbund mit der Lotbasismaterialschicht und/oder eine Lotfolie und/oder mit der mindestens einen Metallschicht bereitgestellt wird.

Insbesondere ist es durch die Nutzung einer separat ausgeführten Aktivmetallschicht möglich, diese vergleichsweise dünn auszugestalten, wodurch die anspruchsgemäßen vergleichsweise dünnen Dicken der Bindungsschicht realisierbar sind, insbesondere gemittelt über verschiedenen Messerwerte innerhalb der festgelegten Fläche bzw. Flächen. Beispiele für ein Aktivmetall sind Titan (Ti), Zirkonium (Zr), Hafnium (Hf), Chrom (Cr), Niob (Nb), Cer (Ce), Tantal (Ta), Magnesium (Mg), Lanthan (La) und Vanadium (V). Hierbei ist darauf zu achten, dass die Metalle La, Ce, Ca und Mg leicht oxidieren können. Ferner wird angemerkt, dass die Elemente Cr, Mo und W keine klassischen Aktivmetalle sind, sich aber als Kontaktschicht zwischen $Si_3N_4$ und der mindestens einem Metallschicht bzw. dem Lotsystem bzw. Lotmaterial eignen, da sie mit der mindestens einen Metallschicht, beispielsweise Kupfer, keine intermetallischen Phasen bilden und keine Randlöslichkeit haben.

Insbesondere handelt es sich bei dem Lotbasismaterial um ein metallbasiertes Basismaterial, vorzugsweise um ein silberbasiertes oder ein kupferbasiertes Basismaterial. In einem silberbasierten Basismaterial ist Silber die Hauptkomponente, d. h. der Bestandteil mit dem bezüglich der Gewichtsprozente höchsten Anteil, während in einem kupferbasierten Basismaterial Kupfer die Hauptkomponente ist. Beispiele für ein silberbasiertes Basismaterial sind AgCu, insbesondere AgCu28, AgCuIn, AgCuSn und AgCuGa. Beispiele für ein kupferbasiertes Basismaterial sind Kupfer CuSn, CuAg, CuIn, CuGa, CuInSn, CuInMn, CuGaSn. Auch ist es vorstellbar, ein Lotbasismaterial auf Basis von NiCrMn oder SnCu zu verwenden.

Vorzugsweise ist es vorgesehen, dass in der angeordneten Aktivmetallschicht ein Anteil an nichtmetallischen Verunreinigungen kleiner ist als 0,1 Gew-%, bevorzugt kleiner als 0,05 Gew-% und besonders bevorzugt kleiner als 0,01 Gew-%. Durch die Minimierung von Verunreinigungen ist es in vorteilhafter Weise möglich die Schichtdicke kleiner zu gestalten, da im Falle einer Verunreinigung nur ein Teil des vorhandenen Aktivmetalls zur Verbindung der mindestens einen Metallschicht mit dem Isolationselement beitragen kann, während der Rest des Aktivmetalls durch die Verunreinigungen gebunden wird. Durch die entsprechende Sicherstellung eines vergleichsweise geringen Anteils an Verunreinigungen wird so eine effektivere Anbindung realisiert, die es gestattet, den Anteil des Aktivmetalls zu reduzieren, wodurch sich wiederrum die Bindungsschicht dünner gestalten lässt.

Weiterhin ist es bevorzugt vorgesehen, dass ein physikalisches und/oder chemisches Gasphasenabscheiden oder elektrochemisches Abscheiden derart durchgeführt wird, dass eine Dichte des auf dem Isolationselement aufgetragenen Aktivmetalls realisiert wird, die größer ist als 90 % einer theoretischen Dichte des Aktivmetalls, bevorzugt größer als 95 % der theoretischen Dichte und besonders bevorzugt größer als 99% der theoretischen Dichte. Unter der theoretischen Dichte des Aktivmetalls versteht der Fachmann insbesondere diejenige Dichte, die in einem Datenblatt für das Aktivmetall zu finden ist, ohne das künstliche Hohlräume bzw. Poren in das Aktivmetall eingebracht sind. Insbesondere die vergleichsweise hohen Dichten verhindern, dass während des Anbindens Sauerstoff, Stickstoff und/oder Kohlenstoff in der Aktivmetallschicht vorliegt, was wiederrum als Verunreinigung zu einer ungewünschten Bindung des Aktivmetalls führen könnte. In entsprechender Weise wird durch die erhöhte Dichte in der Aktivmetallschicht der Anteil, der wirksam für die Verbindung zwischen der mindestens einen Metallschicht und dem Keramikelement verwendet werden kann, erhöht, was wiederum dazu führt, dass man die Aktivmetallschicht als solche dünner ausgestalten kann.

Vorzugsweise ist es vorgesehen, dass eine Aktivmetallschicht verwendet wird, deren Dicke zwischen 10 nm und 1000 nm liegt, bevorzugt zwischen 50 nm und 750 nm, besonders bevorzugt zwischen 100 und 500 nm. Weiterhin ist es bevorzugt vorgesehen, dass das Aktivmetall mittels eines physikalischen und/oder chemisches Gasphasenabscheidens auf dem Isolationselement und/oder dem Lotbasismaterial, das vorzugsweise ebenfalls als Folie ausgebildet ist, aufgetragen wird. Beispielsweise ist es auch vorstellbar, dass das Aktivmetall zusammen mit dem Lotmaterial auf die gewünschte Dicke heruntergewalzt wird, um eine vergleichsweise dünne Bindungsschicht zwischen der mindestens einen Metallschicht und dem Isolationselement auszubilden.

Vorzugsweise wird eine Lotfolie verwendet, die kleiner ist als 20 $\mu$m, bevorzugt kleiner als 12 $\mu$m und besonders bevorzugt kleiner als 8 $\mu$m aufweist. Beispielsweise nimmt die Dicke der Lotschicht einen Wert zwischen 2 und 20 $\mu$m oder zwischen 2 und 5 $\mu$m zwischen bevorzugt zwischen 8 und 15 $\mu$m und besonders bevorzugt zwischen 5 und 10 $\mu$m an. Weiterhin ist es vorstellbar, dass das Lotbasismaterial als Folie, als Paste, als eine durch physikalisches und/oder chemisches Abscheiden entstandene Schicht, und/oder als galvanisch gebildete Schicht bereitgestellt wird.

Weiterhin ist es bevorzugt vorgesehen, dass eine Rauigkeit $R_a$ einer Oberfläche des Isolationselements zumindest bereichsweise kleiner ist als 1,0 $\mu$m, bevorzugt kleiner als 0,7 $\mu$m und besonders bevorzugt kleiner als 0,5 $\mu$m. Durch die Reduktion der Rauigkeit an der Oberfläche des Isolationselements ist es in vorteilhafter Weise möglich, Lufteinschlüsse oder Hohlbereiche zu vermeiden, in denen sich Sauerstoff ansammeln kann, der wiederrum im Sinne einer Verunreinigung der effektiven Nutzung des Aktivmetalls zur Anbindung der mindestens einen Metallschicht an das Isolationselement abträglich wäre. Insbesondere wird eine Mittenrauigkeit angenommen. Der Mittenrauwert, dargestellt durch das Symbol $R_a$, gibt einen mittleren Abstand eines Messpunktes - auf der Oberfläche - zu einer Mittellinie an. Die Mittellinie schneidet innerhalb einer Bezugsstrecke das wirkliche Profil so, dass eine Summe der Profilabweichungen in einer parallelen Ebene zur Mittellinie auf eine Länge der Bezugsstrecke verteilt wird.

Vorstellbar ist ebenfalls, dass die Rauigkeit $R_a$ einer Oberfläche des Isolationselements zumindest bereichsweise größer ist als 1,0 $\mu$m, bevorzugt zwischen 0,4 $\mu$m und 1,5 $\mu$m und besonders bevorzugt zwischen 0,75 und 1,25 $\mu$m. Insbesondere hat sich herausgestellt, dass mit zunehmender Rauigkeit auch der Flächenwiderstand zunimmt.

Weiterhin hat es sich herausgestellt, dass es möglich ist, den äußersten Rand der mindestens einen Metallschicht, insbesondere an der dem Isolationselement zugewandten Seite, derart auszugestalten, dass er weniger zu einer Fransenbildung neigt. Während es bei den aus dem Stand der Technik bekannten Verfahren üblich ist, dass sich ein ausgefranster äußerster Rand ausbildet, ist es möglich, diese Fransenbildung zu unterdrücken. Die Seitenlänge der mindestens einen Metallschicht im Randbereich bestimmt sich vorzugsweise als Erstreckung zwischen einer oberen Kante der mindestens einen Metallschicht an der dem Isolationselement abgewandten Seite, und einer unteren Kante, die die Metallschicht an der dem Isolationselement zugewandten Seite am äußersten Umfang begrenzt. Dabei wird ein Stoffschlussmittel, wie beispielswiese ein Lotmaterial oder dessen Rückstände, der unteren Kante der mindestens einen Metallschicht zugerechnet. Im Rahmen der Strukturierung der mindestens einen Metallschicht ist es im Stand der Technik üblich, dass die untere Kante entlang einer Umlaufrichtung um einen durch die Strukturierung entstandenen Metallabschnitte nicht geradlinig verläuft, wodurch ein fransenartiger Verlauf bedingt wird. Dies führt dazu, dass die Länge der mindestens einen Metallschicht zwischen der oberen Kante und der unteren Kante, bemessenen in einer parallel zur Haupterstreckungsebene verlaufenden Richtung, entlang der Umlaufrichtung variiert. Dies entspricht der Fransenbildung am äußersten Umfang der mindestens einen Metallschicht. Dabei sind die Längen des äußersten Rand bemessenen zwischen der oberen Kante und der unteren Kante der mindestens einen Metallschicht stochastisch verteilt.

Es hat sich herausgestellt, dass es möglich ist diese Variation in der Länge des äußersten Rands der mindestens einen Metallschicht einzuschränken. Insbesondere ist es vorgesehen, dass eine Standardabweichung einer Länge des äußersten Randbereichs der mindestens einen Metallschicht, bemessen zwischen einer oberen und unteren Kante der mindestens einen Metallschicht in einer parallel zur Haupterstreckungsebene verlaufenden Richtung, einen Wert kleiner als 0,4, bevorzugt kleiner als 0,2 und besonders bevorzugt kleiner als 0,1 annimmt. Durch die geringere Streuung in Hinblick auf die Länge der mindestens einen Metallschicht im Randbereich ist es in vorteilhafter Weise möglich unter Berücksichtigung von etwaigen Fertigungstoleranzen benachbarte Metallabschnitte näher aneinander zu realisieren. Dies unterstützt die Bildung von möglichst kompakten Leiterplatten.

Weiterhin ist es bevorzugt vorgesehen, dass die mindestens eine Metallschicht und/oder die mindestens eine weitere Metallschicht mittels eines Aktivlotverfahrens und/oder eines heißisostatischen Pressens und/oder eines DCB-Verfahrens an das Isolationselement angebunden wird.

Beispielsweise ist es vorgesehen, dass ein Verfahren zur Herstellung eines Metall-Keramik-Substrats vorgesehen ist, umfassend:

- Bereitstellen einer Lötschicht, insbesondere in Form mindestens einer Lötfolie bzw. Hartlotfolie,
- Beschichten des Isolationselements und/oder der mindestens einen Metallschicht und/oder der mindestens einen Lötschicht mit mindestens einer Aktivmetallschicht,
- Anordnen der mindestens einen Lötschicht zwischen dem Isolationselement und der mindestens einen Metallschicht entlang einer Stapelrichtung unter Ausbildung eines Lötsystems, das die mindestens eine Lötschicht und die mindestens eine Aktivmetallschicht umfasst, wobei ein Lotmaterial der mindestens einen Lötschicht vorzugsweise frei von einem schmelzpunkterniedrigenden Material bzw. von einem phosphorfreien Material ist, und
- Anbinden der mindestens einen Metallschicht an die mindestens eine Keramikschicht über das Lötsystem mittels eines Aktivlotverfahrens.

Insbesondere ist dabei ein mehrschichtiges Lötsystem aus mindestens einer Lötschicht, vorzugsweise frei von schmelzpunkterniedrigenden Elementen, besonders bevorzugt aus einer phosphorfreien Lötschicht, und mindestens einer Aktivmetallschicht, vorgesehen. Die Separation der mindestens einen Aktivmetallschicht und der mindestens einen Lötschicht erweist sich insbesondere deswegen als vorteilhaft, weil dadurch vergleichsweise dünne Lötschichten realisierbar sind, insbesondere wenn es sich bei der Lötschicht um eine Folie handelt. Für aktivmetallhaltige Lötmaterialien müssen andernfalls vergleichsweise große Lötschichtdicken wegen der spröden intermetallischen Phasen bzw. des hohen E-Moduls und hoher Streckgrenze der gängigen Aktivmetalle und deren intermetallischen Phasen, die die Umformung der Lötpaste bzw. Lötschicht behindern, realisiert werden, wodurch die minimale Schichtdicke durch die Fertigungseigenschaften des aktivmetallhaltigen Lötmaterials begrenzt wird. Entsprechend bestimmt für aktivmetallhaltige Lötschichten nicht die für das Fügeverfahren erforderliche Mindestdicke die minimale Lötschichtdicke der Lötschicht, sondern die für die technisch realisierbare minimale Schichtdicke der Lötschicht bestimmt die minimale Lötschichtdicke der Lötschicht. Dadurch ist diese dickere, aktivmetallhaltige Lötschicht teurer als dünne Schichten. Unter phosphorfrei versteht der Fachmann insbesondere, dass der Anteil an Phosphor in der Lötschicht kleiner ist als 150 ppm, kleiner als 100 ppm und besonders bevorzugt kleiner als 50 ppm.

Vorzugsweise umfasst die Lötschicht, insbesondere die phosphorfreie Lotschicht, mehrere Materialien zusätzlich zu dem reinen Metall. Beispielsweise ist Indium ein Bestandteil des verwendeten Lotmaterials in der Lötschicht.

Weiterhin ist es vorstellbar, dass das Lotmaterial zur Ausbildung der Lötschicht durch ein physikalisches und/oder chemisches Gasphasenabscheiden und/oder galvanisch auf die Aktivmetallschicht und/oder die mindestens eine Metallschicht aufgetragen wird. Dadurch ist es in vorteilhafter Weise möglich, vergleichsweise dünne Lotschichten im Lötsystem, insbesondere in einer homogenen Verteilung, zu realisieren.

Beispielswiese sind bei der Herstellung des Trägersubstrats, insbesondere des Metall-Keramik-Substrats, weitere Schritte vorgesehen, umfassend: - Bereitstellen eines Keramikelements und einer Metalllage,

- Bereitstellen eines gasdichten Behälters, der das Keramikelement umschließt, wobei der Behälter vorzugsweise aus der Metalllage geformt ist oder die Metalllage umfasst,
- Ausbilden des Metall-Keramik-Substrats durch ein Anbinden der Metalllage an das Keramikelement mittels heißisostatischem Pressen,

wobei zum Ausbilden des Metall-Keramik-Substrats zwischen dem der Metalllage und dem Keramikelement mindestens abschnittsweise eine Aktivmetallschicht oder eine ein Aktivmetall umfassende Kontaktschicht, zur Unterstützung des Anbindens der Metalllage an das Keramikelement, angeordnet wird. Der Behälter wird dabei vorzugsweise als Metallbehälter aus einer Metalllage und/oder einer weiteren Metalllage gebildet. Alternativ ist es auch vorstellbar, dass ein Glasbehälter verwendet wird..

Beim heißisostatischen Pressen ist es insbesondere vorgesehen, dass das Bonden durch Erhitzen unter Druck erfolgt, bei dem die erste und/oder zweite Metalllage des Metallbehälters, insbesondere die spätere Metallschicht des Metall-Keramik-Substrats und eine etwaige dort auftretende eutektische Schicht nicht in die Schmelzphase übertritt. In entsprechender Weise sind beim heißisostatischem Pressen geringere Temperaturen als bei einem Direktmetallanbindungsverfahren, insbesondere einem DCB-Verfahren, erforderlich.

Im Vergleich zu der Anbindung einer Metallschicht an eine Keramikschicht mittels eines Lotmaterials, bei dem üblicherweise Temperaturen unterhalb der Schmelztemperatur der mindestens einen Metallschicht verwendet werden, kann bei der vorliegenden Vorgehensweise in vorteilhafter Weise auf ein Lotbasismaterial verzichtet werden und es wird lediglich ein Aktivmetall benötigt. Die Verwendung bzw. die Nutzung des Drucks beim heißisostatischen Pressen erweist sich dabei zudem als vorteilhaft, weil dadurch Lufteinschlüsse bzw. Hohlräume zwischen der ersten Metalllage und/oder der zweiten Metalllage einerseits und dem Keramikelement andererseits reduziert werden können, wodurch die Ausbildung von Lunkern in ihrer Häufigkeit im gebildeten bzw. gefertigten Metall-Keramik-Substrat reduziert oder gar vermieden werden kann. Dies wirkt sich vorteilhaft auf die Qualität der Bindung zwischen der Metallschicht bzw. der ersten und/oder zweiten Metalllage des Metallbehälters und dem Keramikelement aus. Darüber hinaus ist es in vorteilhafter Weise möglich, das "second etching" zu vereinfachen und Lotreste sowie eine Silbermigration zu vermeiden.

Vorstellbar ist es auch, dass beim heißisostatischen Pressen ein zusätzliches Lotmaterial zwischen das Keramikelement und die mindestens eine Metallschicht eingebracht wird, wobei eine Schmelztemperatur des zusätzlichen Lotmaterials kleiner sein kann als die Temperatur, bei der das heißisostatische Pressen durchgeführt wird, d. h. kleiner als die Schmelztemperatur der mindestens einen Metallschicht.

Vorzugsweise ist es vorgesehen, dass bei einem heißisostatischen Pressen der Metallbehälter in einer Heiz- und Druckvorrichtung einem Gasdruck zwischen 100 und 2000 bar, bevorzugt zwischen 150 und 1200 bar und besonders bevorzugt zwischen 300 und 1000 bar und einer Prozesstemperatur von 300 °C bis zu einer Schmelztemperatur der mindestens einen Metallschicht, insbesondere bis zu einer Temperatur unterhalt der Schmelztemperatur, ausgesetzt wird. Es hat sich in vorteilhafter Weise herausgestellt, dass es so möglich ist, eine Metallschicht, d.h. ein erste und/oder zweite Metalllage des Metallbehälters, an das Keramikelement anzubinden, ohne die erforderlichen Temperaturen eines Direktmetallanbindungsverfahrens, beispielsweise eines DCB- oder einem DAB-Verfahrens, und/oder ohne ein Lotbasismaterial, das beim Aktivlöten verwendet wird. Darüber hinaus gestattet das Nutzen bzw. die Verwendung eines entsprechenden Gasdrucks die Möglichkeit, möglichst lunkerfrei, d. h. ohne Gaseinschlüsse zwischen Metallschicht und Keramikelement ein Metall-Keramik-Substrat zu fertigen. Insbesondere finden Prozessparameter Verwendung, die in der DE 2013 113 734 A1 erwähnt werden und auf die hiermit explizit Bezug genommen wird.

Weitere Vorteile und Eigenschaften ergeben sich aus der nachfolgenden Beschreibung bevorzugter Ausführungsformen des erfindungsgemäßen Gegenstands mit Bezug auf die beigefügten Figuren. Es zeigen:

**Fig. 1:**         Trägersubstrat gemäß einer ersten beispielhaften Ausführungsform der vorliegenden Erfindung;

**Fig. 2**          Bestandteil des Trägersubstrats aus Figur 1 vor dem Fügen;

**Fig. 3:**         Trägersubstrat gemäß einer zweiten beispielhaften Ausführungsform der vorliegenden Erfindung;

**Fig. 4**          Bestandteil des Trägersubstrats aus Figur 3 vor dem Fügen und

**Fig. 5**          Detailansicht eines Trägersubstrats gemäß einer dritten beispielhaften Ausführungsform der vorliegende Erfindung

**Fig. 6a und 6b**  beispielhafte Schnittbilder durch ein Trägersubstrate;

**Fig. 7:**         Zusammenhang der Abzugsfestigkeit zu der Schichtdicke der Haftvermittlerschicht;

**Fig. 8a und 8b**  Verfahren zur Bestimmung des Flächenwiderstands

**Fig. 9**          Ergebnisse für die Flächenwiderstände

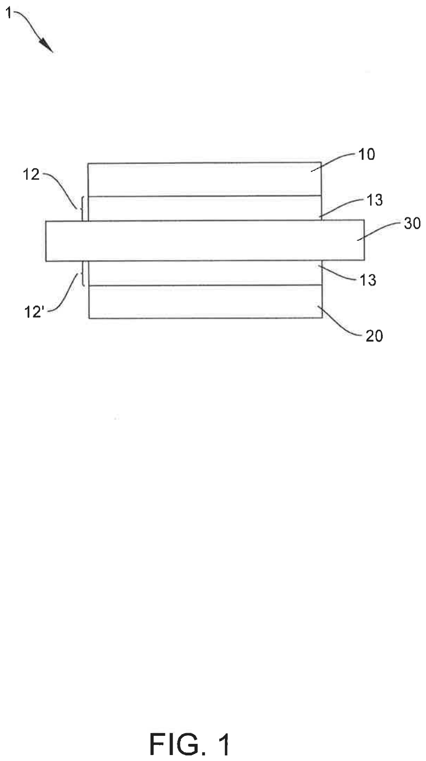

In der **Figur 1** ist ein Trägersubstrat 1 gemäß einer ersten beispielhaften Ausführungsform der vorliegenden Erfindung dargestellt. Solche Trägersubstrate 1, insbesondere in Form eines Metall-Keramik-Substrats, dienen vorzugsweise als Träger bzw. Leiterplatte für elektronische bzw. elektrische Bauteile, die an die mindestens eine Metallschicht 10 des Trägersubstrats 1 an dessen Bauteilseite anbindbar sind. Dabei ist es vorzugsweise vorgesehen, dass die mindestens eine Metallschicht 10 strukturiert ist, um entsprechende Leiterbahnen und/oder Anschlussflächen auszubilden, d. h. im gefertigten Trägersubstrat 1 umfasst die mindestens eine Metallschicht 10 mehrere voneinander elektrisch isolierte Metallabschnitte. Die sich im Wesentlich entlang einer Haupterstreckungsebene HSE erstreckende mindestens eine Metallschicht 10 und ein sich entlang der Haupterstreckungsebene HSE ersteckendes Isolationselement 30 sind dabei entlang einer senkrecht zur Hauptersteckungsebene HSE verlaufenden Stapelrichtung S übereinander angeordnet und vorzugsweise über eine Bindungsschicht 12 miteinander gefügt bzw. verbunden. Vorzugsweise umfasst das Trägersubstrat 1 neben der mindestens einen Metallschicht 10 mindestens eine weitere Metallschicht 20, die in Stapelrichtung S gesehen an der der mindestens einen Metallschicht 10 gegenüberliegenden Seite des Isolationselements 30 angeordnet und über eine weitere Bindungsschicht 12' an das Isolationselement 30 angebunden ist.

Dabei dient die mindestens eine weitere Metallschicht 20 als Rückseitenmetallisierung, die einem Durchbiegen des Trägersubstrats 1, insbesondere des Metall-Keramik-Elements, entgegenwirkt, und/oder als Kühlkörper, der dazu ausgelegt ist, einen Wärmeeintrag, hervorgerufen durch elektrische oder elektronische Bauteile auf dem Metall-Keramik-Substrat 1, abzuführen.

Insbesondere weist das Trägersubstrat 1 eine zwischen der mindestens einen Metallschicht 10 und dem Isolationselement 30 angeordnete Bindungsschicht 12 auf. Es hat sich dabei als vorteilhaft herausgestellt, wenn eine in Stapelrichtung S bemessene Dicke der Bindungsschicht 12 vergleichsweise dünn ist. Außerdem erweist sich eine vergleichsweise dünne Dicke der Bindungsschicht 12 zwischen der mindestens einen Metallschicht 10 und dem Isolationselement 30 als vorteilhaft, wenn zwecks einer Strukturierung der mindestens einen Metallschicht 10 ein Ätzvorgang vorgesehen ist. Beispielsweise lassen sich dadurch schmalere Isolationsgräben, d. h. Abstände zwischen einzelnen Metallabschnitten der mindesten einen Metallschicht 10, realisieren. Beispielsweise lassen sich so Breiten z, gemessen in Richtung parallel zur Haupterstreckungsebene HSE, für den Isolationsgraben zwischen zwei Metallabschnitten deren Dicke 200 $\mu$m bis 400$\mu$m beträgt, realisieren, die kleiner sind als 700 $\mu$m, bevorzugt weniger als 600 $\mu$m und besonders bevorzugt weniger als 500 $\mu$m.

Weiterhin erweist sich die Ausbildung einer dünneren Bindungsschicht 12 insofern als vorteilhaft, dass dadurch auch eine Anzahl an möglichen Fehlern in der Bindungsschichten 12, hervorgerufen durch Materialfehler in einem eventuell verwendeten Lotmaterial, weiter reduziert werden kann.

In dem in Figur 1 dargestellten Beispiel handelt es sich bei der Bindungsschicht 12 insbesondere um eine ein Aktivmetall umfassende Haftvermittlerschicht 13. Vorzugsweise handelt es sich bei Trägersubstrat 1 um ein Metall-Keramik-Substrat, bei dem das Isolationselement 30 ein Keramikelement ist. In diesem Fall wird die Haftvermittlerschicht 13 vorzugsweise aus einer Materialzusammensetzung gebildet, die eine Verbindung aus Komponenten des Keramikelements einerseits und einem Aktivmetall andererseits umfasst. Da es sich hierbei um sehr sprödbrechende Verbindungen handelt, ist eine möglichst dünne Ausgestaltung dieser Haftvermittlerschicht 13 von Vorteil für die Haftfestigkeit der mindestens einen Metallschicht 10 auf dem Isolationselement 30.

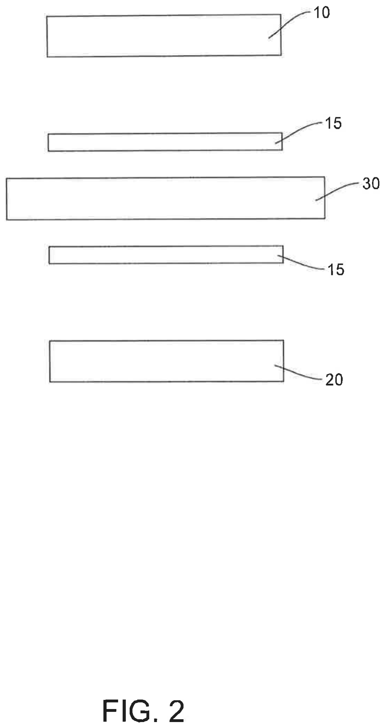

In **Figur 2** ist das Trägersubtrat 1 aus Figur 1 vor dem Fügen dargestellt. Vor dem Fügeprozess ist es vorgesehen, dass in Stapelrichtung S gesehen das Isolationselement 30, d. h. insbesondere das Keramikelement, und die mindestens eine Metallschicht 10 übereinander angeordnet werden, wobei eine Aktivmetallschicht 15 zwischen die mindestens eine Metallschicht 10 und das Isolationselement 30 angeordnet wird.

Weiterhin ist es besonders bevorzugt vorgesehen, dass zur Anbindung der mindestens einen weiteren Metallschicht 20 an der der mindestens einen Metallschicht 10 gegenüberliegenden Seite des Isolationselement 30 ebenfalls eine Aktivmetallschicht 15 zwischen dem Isolationselement 30 und der mindestens einen weiteren Metallschicht 20 angeordnet wird. Dabei sind ebenfalls die mindestens eine weitere Metallschicht 20 und das Isolationselement 30 in Stapelrichtung S übereinander angeordnet. Beispielsweise erfolgt hier die Anbindung der mindestens einen Metallschicht 10 an das Isolationselement 30 mittels eines heißisostatischen Pressens, bei dem unter Druck- und Temperatureinwirkung auf ein Ensemble aus Isolationselement 30, Aktivmetallschicht 15 und der mindestens einen Metallschicht 10 eine Anbindung realisiert wird. Hierzu wird vorzugsweise ein Behälter, verwendet, in dem das Ensemble aus Isolationselement 30, Aktivmetallschicht 15 angeordnet wird. Vorzugsweise bildet ein Teil des gasdichten Metallbehälters die mindestens eine Metallschicht 10 und bildet so den Teil des Ensembles. Alternativ ist auch vorstellbar, dass die Aktivmetallschicht 15 durch ein Energieeintrag, beispielsweise durch Aufwendung von Lichtblitzen, im Rahmen eines "Flash Light Annealing", dahingehend unterstützt wird, dass eine Anbindung der mindestens einen Metallschicht 10 über die Aktivmetallschicht 15 an das Isolationselement 30 erfolgt. Bevorzugt erfolgt das "Flash Light Annealing" nach dem Anordnen der Aktivmetallschicht 15 auf dem Isolationselement 30 und/oder der mindestens einen Metallschicht 10.

Durch den Anbindungsprozess wird die Aktivmetallschicht 15 zur Bindungsschicht 12, insbesondere zur aktivmetallhaltigen Haftvermittlerschicht 13. Insbesondere umfasst die Bindungsschicht 12 ein aktivmetallhaltiges Material, das beispielsweise abhängig von der Keramik unter anderem, Titankarbid, Titanitrid und/oder Titanoxid, vorzugsweise in unterschiedlichen Oxidationsstufen, sein kann.

Vorzugsweise wird die Aktivmetallschicht 15 durch ein physikalisches und/oder chemisches Gasphasenabscheiden, beispielsweise ein Sputtern, auf das Isolationselement 30 und/oder auf die mindestens eine Metallschicht 10 aufgetragen. Hierzu ist es besonders bevorzugt vorgesehen, dass beim physikalischen Gasphasenabscheiden eine Aktivmetallschicht 15 realisiert wird, deren Dichte größer ist als 90 % einer theoretischen Dichte des Aktivmetalls, bevorzugt größer als 95 % der theoretischen Dichte des Aktivmetalls und besonders bevorzugt größer als 99% der theoretischen Dichte des Aktivmetalls. Dadurch wird in vorteilhafter

Weise ein Anteil an Luft, insbesondere ein Anteil an Sauerstoff, in der Aktivmetallschicht 15 während des Anbindungsprozesses reduziert, der andernfalls bewirken würde, dass nur ein reduzierter Teil des Aktivmetalls, d. h. nicht ein maximal möglicher Anteil, zur Bindung der mindestens einen Metallschicht 10 an das Isolationselement 30 verwendet werden kann.

Insbesondere hat es sich als vorteilhaft erwiesen, wenn ein Anteil von Verunreinigungen in der Aktivmetallschicht 15 kleiner ist als 1 Gew-%, bevorzugt kleiner als 0,7 Gew-% und besonders bevorzugt kleiner als 0,5 Gew-%. Dies gestattet ein möglichst dünnes Auftragen der Aktivmetallschicht 15, was dazu führt, dass sich eine vergleichsweise dünne Bindungsschicht 12 ausbildet. Dabei ist die Größe der Verunreinigung beispielsweise von Reinheit eines Trägerstoffes abhängig. Beispielsweise weist die Schichtdicke der Aktivmetallschicht 15, gemessen in Stapelrichtung S, vor dem Verbinden der mindestens einen Metallschicht 10 an das Isolationselement 30 über die Aktivmetallschicht 15 eine Dicke von 10 nm - 1000 nm bevorzugt zwischen 50 nm - 150 nm und besonders bevorzugt zwischen 100 nm - 500 nm auf. Weiterhin ist es besonders bevorzugt vorgesehen, dass nach dem Fügen bzw. Anbinden der mindestens einen Metallschicht 10 an das Isolationselement 30 eine Strukturierung vorgenommen wird, insbesondere mittels eines Ätzens bzw. Ätzvorgangs. Hierzu erfolgt die Strukturierung indem sowohl die Abschnitte bzw. Teilbereiche der mindestens einen Metallschicht 10 und der Bindungsschicht 12 wieder entfernt werden, um die Metallabschnitte in der mindestens einen Metallschicht 10 voneinander elektrisch zu isolieren.

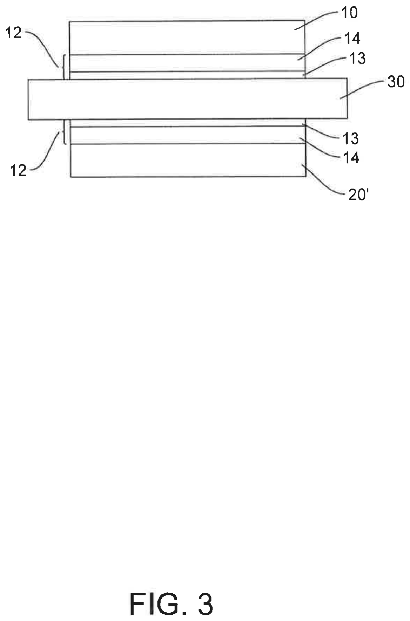

In der **Figur 3** ist ein Trägersubstrat 1 gemäß einer zweiten beispielhaften Ausführungsform dargestellt. Dabei unterscheidet sich die Ausführungsform der Figur 3 von derjenigen aus der Figur 1 nur dahingehend, dass das Trägersubstrat 1 als Bindungsschicht 12 neben einer Haftvermittlerschicht 13 eine Lotbasisschicht 14 aufweist. Die Lotbasisschicht 14 umfasst insbesondere als Material einen Lothauptbestandteil des verwendeten Lotbasismaterials 16 bzw. den wesentlichen Bestandteil des Lotbasismaterials 16. Vorzugsweise ist die Lotbasisschicht 14 aus Silber geformt, insbesondere wenn es sich um ein silberbasiertes Lotbasismaterial 16 handelt.

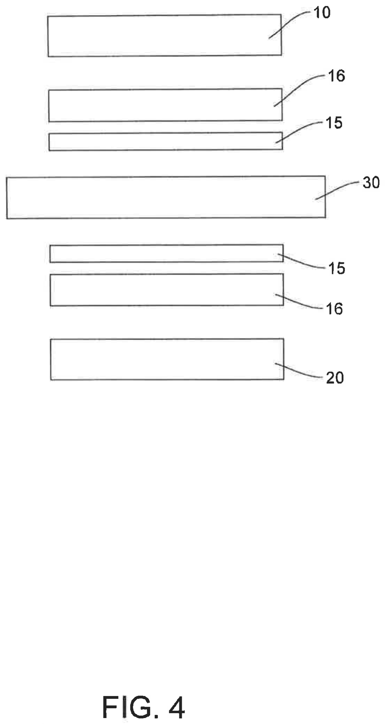

In **Figur 4** ist das Ausführungsbeispiel aus Figur 3 vor dem Fügen dargestellt. Im Gegensatz zu dem System aus der Figur 2 ist es hierbei vorgesehen, dass neben der Aktivmetallschicht 15 ein Lotbasismaterial 16 bereitgestellt wird, wobei das Lotbasismaterial 16 zwischen dem Isolationselement 30 und der mindestens einen Metallschicht 10 in Stapelrichtung S gesehen angeordnet ist. Vorzugsweise ist das Lotbasismaterial 16 in Stapelrichtung S gesehen zwischen der Aktivmetallschicht 15 und der mindestens einen Metallschicht 10 angeordnet. Durch einen Lotprozess, bei dem man das zusammengesetzte Ensemble aus Isolationselement 30, Aktivmetallschicht 15, Lotmaterial 16 und mindestens einer Metallschicht 10 einer entsprechenden Prozesstemperatur aussetzt, erfolgt die Bindung der mindestens einen Metallschicht 10 an das Isolationselement 30 über ein Lotsystem, das die Aktivmetallschicht 15 und das Lotbasismaterial 16 umfasst. Gleiches gilt für die Anbindung der mindestens einen weiteren Metallschicht 20 an das Isolationselement 30 im Beispiel der Figur 4. Vorzugsweise handelt es sich bei dem Lotbasismaterial 16 um eine Folie, die zum Fügen zwischen die mindestens eine Metallschicht 10 und/oder die mindestens eine weitere Metallschicht 20 einerseits und dem Isolationselement 30 andererseits angeordnet wird. Dabei ist es vorstellbar, dass die Aktivmetallschicht 15 durch ein physikalisches und/oder chemisches Gasphasenabscheiden auf dem als Folie ausgebildeten Lotmaterial bzw. Lotbasismaterial 16 aufgetragen wird. Insbesondere hat es sich herausgestellt, dass mittels der Verwendung einer separaten Aktivmetallschicht 15, insbesondere zusammen mit einem Lotbasismaterial 16, es möglich ist, vergleichsweise dünne Bindungsschichten 12 zu realisieren.

Weiterhin hat es sich als vorteilhaft herausgestellt, dass unter Verwendung einer separaten Aktivmetallschicht 15, wie es in den Ausführungsbeispielen der Figuren 1 bis 4 dargestellt ist, möglich ist, eine flächige und durchgehende Bindungsschicht 12 zu realisieren. Dies ist beispielsweise im Falle der Verwendung eines Pastenmaterials, das sowohl Lotbasismaterial 16 als auch Aktivmetall umfasst, nicht sichergestellt, wenn eine gleiche Titanmenge angenommen wird oder eine gleich dickes Lotsystem verwendet wird. Hier entstehen statistisch verteilte Anbindungsfehler im Bereich der Bindungsschicht. In entsprechender Weise ist es durch die gezielte flächige bzw. durchgehende Anbindung der mindestens einen Metallschicht 10 an das Isolationselement 30 möglich, eine ununterbrochene d. h. durchgehende Bindungsschicht 12 zu realisieren, die das Bindungsverhalten der mindestens einen Metallschicht 10 an das Isolationselement 30 signifikant verbessert. Vorzugsweise nimmt ein Verhältnis zwischen Bereichen, in denen zwischen der mindestens einen Metallschicht 10 und dem Isolationselement 30 keine Bindungsschicht 12 ausgebildet ist, zu Bereichen, bei denen zwischen der mindestens einen Metallschicht 10 und dem Isolationselement 30 eine Bindungsschicht 12 ausgebildet ist, einen Wert an, der kleiner als 0,05, bevorzugt kleiner als 0,025 und besonders bevorzugt kleiner als 0,01 ist. Dabei ist es insbesondere vorgesehen, dass zur Bestimmung dieses Verhältnisses nur diejenigen Abschnitte des Trägersubstrats 1 herangezogen werden, die nicht strukturiert sind. Mit anderen Worten: am gefertigten Trägersubstrat 1 bezieht sich das besagte Verhältnis auf einen Metallabschnitt und/oder mehrere Metallabschnitte der mindestens einen Metallschicht 10 oder der mindestens einen weiteren Metallschicht 20. Vorzugsweise stellt sich das Verhältnis über das gesamte Metall-Keramik-Substrat bzw. das ganze Trägersubstrat 1 ein, wobei die einzelnen Teilbereiche über die separaten Metallabschnitte jeweils aufsummiert werden.

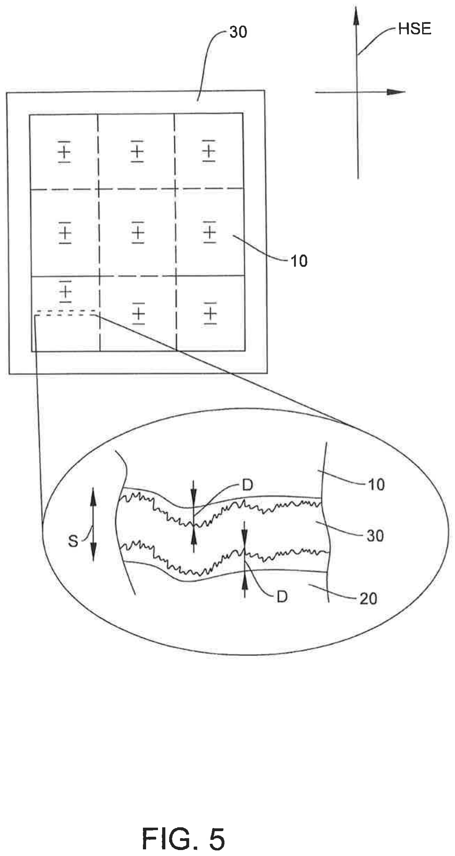

In **Figur 5** ist ein Trägersubstrat 1 gemäß einer dritten beispielhaften Ausführungsform der vorliegenden Erfindung dargestellt. Insbesondere zeigt die obere Hälfte eine Draufsicht auf das Trägersubstrat 1 in einer Blickrichtung, die im Wesentlichen der Stapelrichtung S entspricht. Entsprechend ist die mindestens eine Metallschicht 10 zu erkennen und die gegenüber dem äußersten Rand der mindestens einen Metallschicht 10 vorstehende Oberseite des Isolationselements 30. Dieser vorstehenden bzw. überstehenden Teilabschnitt, ein sogenannter Pull-back, dient insbesondere zur Vermeidung eines elektrischen Überschlags zwischen der mindestens einen Metallschicht 10 und der mindestens einen weiteren Metallschicht 20 an einer Rückseite des Isolationselements 30. Zur quantitativen Bestimmung der Dicke D der Bindungsschicht 12 ist es bevorzugt vorgesehen, dass diese jeweils an verschiedenen Positionen innerhalb verschiedener Flächen F, bevorzugt in mehreren Rechtecken, die zusammen die mindestens eine Metallschicht 10 bilden bzw. zusammengesetzt sich über die gesamte Oberfläche des Trägersubstrats erstrecken, bestimmt werden und anschließend ein Mittelwert bestimmt wird. Im dargestellten Beispiel ist die Metallschicht in neun etwa gleichgroße Rechtecke bzw. Quadrate, d. h. Flächen, eingeteilt. In jedem der neun Flächen F werden mindestens zwei, bevorzugt drei, Schnittbilder mittels eines REM-Verfahrens aufgenommen. In den einzelnen Schnittbildern werden gemittelte Dicken D für die Bindungsschicht 12, insbesondere die Haftvermittlerschicht 13 entlang der Schnittebene bestimmt. Die Schnittebene verläuft dabei senkrecht zur Haupterstreckungsebene HSE. Anschließend wird das arithmetische Mittel aller bestimmten Dicken in den Schnittbildern bestimmt. Dadurch kann in vorteilhafter Weise mitberücksichtigt werden, dass das Trägersubstrat 1 bzw. das Isolationselement 30 in der Regel eine Ondulation, d. h. eine Welligkeit, aufweist, die dazu führt, dass im Rahmen eines Fertigungsprozesses bzw. Anbindungsprozesses das Lotbasismaterial 16 in Täler des Isolationselements 30 an dessen Oberseite einfließt, was dazu führt, dass sich entlang der Haupterstreckungsebene HSE eine Dicke D der Bindungsschicht 12 einstellt, die moduliert ist. Dennoch hat es sich herausgestellt, dass die vorteilhaft beschriebenen Effekte und Wirkungen sich auch dann einstellen, wenn die Dicke D vergleichsweise dünn ist, insbesondere dünner als eine vergleichbare Bindungsschichten 12, die sich bei der Verwendung von klassischen pastösen Lotmaterialien 16 einstellt. Zur Bestimmung der dem Schnittbild zugeordneten Dicke D kann beispielsweise die Dicke D entlang einer Schnittebene kontinuierlich durchgehend aufgenommen werden, d. h. integriert werden, oder in dem Bild durch mehrere diskrete Messungen mit anschließender Mittelwertbestimmung erfasst werden.

Bevorzugt ist es vorgesehen, dass eine aufsummierte Dicke der Bindungsschicht 12 und der weiteren Bindungsschicht 12', die sich zwischen der mindestens einen weiteren Metallschicht 20 und dem Isolationselement 30 ausbildet, heranzuziehen.

Dabei sind jeweils die einander in Stapelrichtung S gesehenen gegenüberliegenden bzw. deckungsgleich zueinander angeordneten Dicken D der Bindungsschicht 12 und der weiteren Bindungsschicht 12' aufzusummieren. Die aufsummierte Dicke D wird dabei wiederrum an verschiedenen Positionen in der Fläche F bzw. den Flächen F ermittelt und anschließend bevorzugt über mehrere Flächen bzw. mehreren Rechtecken, die zusammen die mindestens eine Metallschicht 10 bilden, ermittelt. Insbesondere ist es mit dem Begriff gemittelt gemeint, dass über die gesamte mindestens eine Metallschicht 10 in verschiedenen Flächenbereichen bzw. Rechtecken eine bestimmte Anzahl, vorzugsweise insgesamt mehr als 25 Messwerte, besonders bevorzugt mehr als 100 Messwerte und besonders bevorzugt mehr als 500 Messwerte, herangezogen werden, wobei in jedem Flächenbereich bzw. Rechteck die Messwerte stochastisch über die Fläche F verteilt sind.

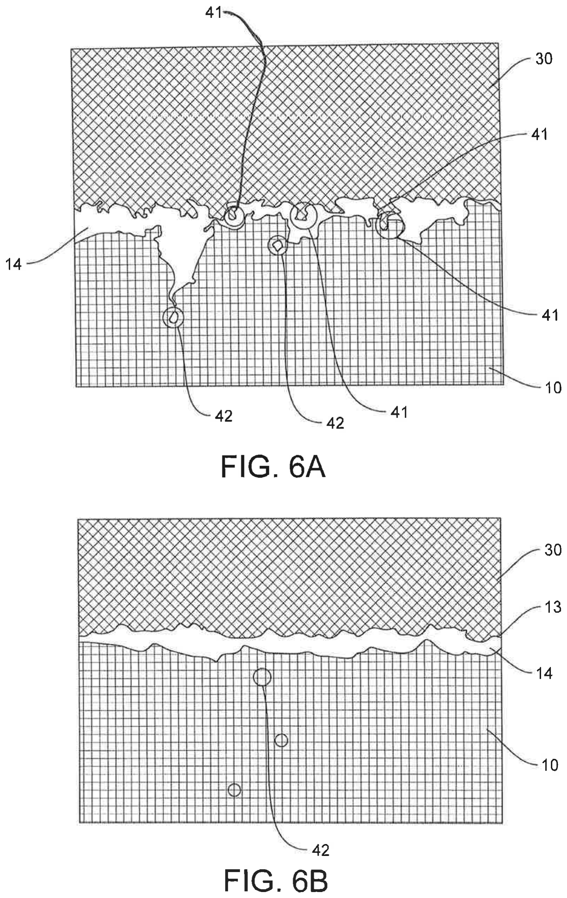

In den **Figuren 6a und 6b** sind zwei beispielhafte Schnittbilder durch ein Trägersubstrate 1 dargestellt. Insbesondere handelt es sich um Kupfer-Keramik-Substrate. Während in der Figur 6a ein Kupfer-Keramik-Substrat dargestellt ist, zu dessen Herstellung eine klassische Lötpaste verwendet wurde, wurde das Kupfer-Keramik-Substrat der Figur 6b mittels einer Aktivmetallschicht 15, die mittels PVD-Verfahren aufgetragen wurde, und mittels eines Lotbasismaterials 16 hergestellt.

Die klassische silberbasierte Lötpaste beinhaltete dabei Titan als Aktivmetall und der Anteil des Titans in der Lötpaste lässt sich einer $1,5\ \mu m$ dicken Aktivmetalläquivalenzschichtdicke zuordnen, während die mittels PVD-Verfahren aufgetragene Aktivmetallschicht eine Dicke D von 300 nm aufweist. Als Lotbasismaterial 16 wurde AgCuIn mit einer Schichtdicke von $20\ \mu m$ verwendet.

Zunächst lassen die dargestellten Figuren als hellen Streifen die Lotbasisschicht 14 erkennen. Dabei lassen beide Schnittbilder auch Einschlüsse 42 aus Silber in der Kupferschicht, d. h. der mindestens einen Metallschicht 10, erkennen. Diese Einschlüsse 42 in der Kupferschicht sind nicht bei der Schichtdickenmessung der Bindungsschicht 13 zu berücksichtigen.

Die dargestellten Ausschnitte aus den mittels REM-Verfahren aufgenommenen Bildern zeigen, dass sich eine homogen verteilte Bindungsschicht 13 im Schnittbild 6b ausbildet. Darüber hinaus ist festzustellen, dass die Anzahl von spröden intermetallischen Phasen 41 im Wesentlichen in der Bindungsschicht 13 zu finden sind, die mit der klassischen Lötpaste hergestellt wurde. Dabei sind die spröden intermetallischen Phasen 41 sowohl in der Lotbasisschicht 14 als auch in der Haftvermittlerschicht 13 zu finden.

Die Anzahl, Häufigkeit bzw. Größe der spröden intermetallischen Phasen 41 hat wiederum Einfluss auf die Abzugsfestigkeit, insbesondere derart, dass mit Abnahme der spröden intermetallischen Phasen 41 die Abzugsfestigkeit vergrößert wird. Die Ausbildung der spröden intermetallischen Phasen 41 ist dabei an die Menge an Aktivmetall, vorliegend an Titan, gebunden.

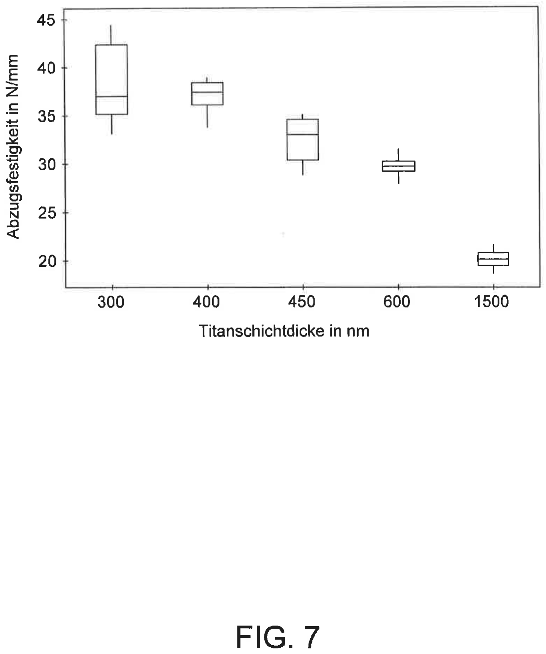

Dies führt zu dem Zusammenhang der Abzugsfestigkeit zu der Schichtdicke der Haftvermittlerschicht 13., der in **Figur 7** dargestellt ist. Es ist dabei zu erkennen, dass mit abnehmender Dicke der Titanschicht bzw. der äquivalenten Dicke auf Basis der verwendeten Titanmenge bei Lotpasten die Abzugsfestigkeit in N/mm zunimmt.

Die hier bestimmten Abzugsfestigkeiten wurden wie folgt bestimmt:

Zunächst wird ein Trägersubstrat 1 bereitgestellt, bei dem mittels Lotverfahren eine 0,8 mm dicke Kupferschicht beidseitig auf ein Keramikelement angebunden wurde. Für einen Abzugstest wird das Kupfer folgendermaßen strukturiert: Länge x Breite: 105 mm x 5 mm. Das Trägersubstrat wird in eine Zugprüfmaschine eingespannt. Der Kupferstreifen wird hier mit einer gleichförmigen Geschwindigkeit von 10mm/min im 90° (+/- 5°) Winkel von der Keramikoberfläche abgezogen. Eine aufzuwendende Kraft wird kontinuierlich über die Länge des Streifens bzw. der Messung aufgezeichnet. Es wird der Mittelwert aus dem Wertebereich der aufzuwendenden Abzugskräfte zwischen 10% und 90% der Messlänge gebildet und dann auf die Breite des Abzugsstreifens in N/mm normiert.

Insbesondere hat es sich gezeigt, dass der Anteil an spröden intermetallischen Phasen 42 abhängt von einem Aktivmetallanteil in der Bindungsschicht 13, insbesondere in der Haftvermittlerschicht 13. Der Anteil des Aktivmetalls, insbesondere des Titans, lässt sich wiederum an einem Flächenwiderstand feststellen, der mit abnehmenden Anteil an Aktivmetall zunimmt.

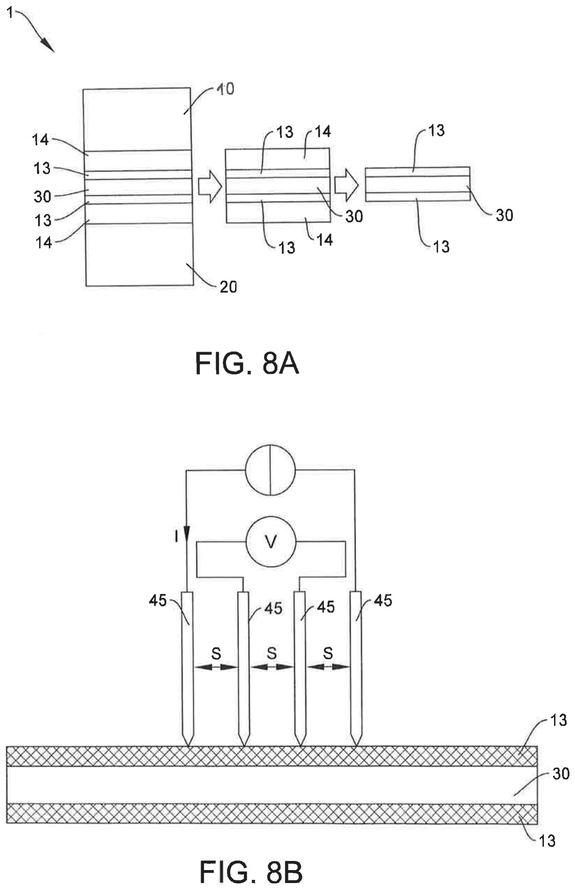

In den **Figuren 8a und 8b** ist ein Verfahren zur Bestimmung des Flächenwiderstands dargestellt. Hierbei wird zunächst am Trägersubstrate 1, die mindestens eine Metallschicht 10 und anschließend die Lotbasisschicht 14 weggeätzt, so dass im Wesentlichen nur noch die Haftvermittlerschicht 13 übrig bleibt (siehe Figur 8a). Anschließend wird der Flächenwiderstand mittels einer Vierpunkt-Methode bestimmt.

Hierzu wird eine Anordnung aus vier Messspitzen 45 verwenden, die mit gleichem Abstand s von 5 mm in einer Reihe nebeneinander angeordnet sind. Diese Anordnung ist in Figur 8b illustriert. Die abgerundeten Messspitzen 45 werden mit eine Andruckkraft von 1.5 N oder weniger auf die freigeätzte Haftvermittlerschicht 13 aufgesetzt. Dabei wird darauf geachtet, dass ein ausreichender Distanzierung der Messspitzen 45 zum Rand der Probe vorlegt, nämlich mehr als ein Dreifaches des Abstands s zwischen zwei benachbarten Messspitzen 45. Während die beiden äußeren Messspitzen 45 einen Strom I veranlassen, wird mit den beiden innenliegenden Messspitzen 45 eine Spannung V bestimmt. Zur Vermeidung von Erwärmungen in der Probe wird dabei ein Strom I unterhalb von 50 mA verwendet. Entsprechend bestimmt sich der Widerstand $R$ aus dem Verhältnis der Spannung V zur Stromstärke I. Anschließend bestimmt sich der Flächenwiderstand $R_{\blacksquare}$ in Ohm/sq gemäß folgender Formel

$$R_{\blacksquare} = \frac{\rho}{d} = \frac{\pi}{\ln(2)} \cdot R \approx 4.5324 \cdot R$$

Gemäß der oben beschriebenen Weise wurden Haftvermittlerschichten 13 gemessen, die mittels der folgenden Lotmaterialen hergestellt wurden:

| Probe | Lot | Form | Titan |
|---|---|---|---|
| Referenz 1 | AgCu26Ti5In2 | Paste 30 $\mu$m | In Paste 1500 nm |
| Referenz 2 | AgCu26Ti5In2 | Paste 30 $\mu$m | In Paste 1500 nm |
| AMB V 1 | AgCu27.4In2 | Folie 8 $\mu$m | PVD 300 nm |
| AMB V 2 | AgCu27.4In2 | Folie 8 $\mu$m | PVD 300 nm |
| AMB V 3 | AgCu27.4In2 | Folie 8 $\mu$m | PVD 300 nm |
| AMB V 4 | AgCu27.4In2 | Folie 6 $\mu$m | PVD 300 nm |
| AMB V 5 | AgCu27.4In2 | Folie 10 $\mu$m | PVD 300 nm |

Als Referenzen (Referenz 1 und Referenz 2) werden hierbei klassische Lotpasten verwendet, die als Bestandteil Titan als Aktivmetall aufweisen. Der in der Paste beinhaltete Anteil an Titan entspricht dabei einer Aktivmetalläquivalenzschichtdicke von 1500 nm. In diesem Fall ist die Dicke der Paste etwa 30 $\mu$m. Eine derartige Äquivalenzschichtdicke wird anhand des Anteils an Titan in der Paste bestimmt, da das Titan Bestandteil der Paste ist und in dieser gleichmäßig verteilt ist. Die Paste wurde dabei mit einer Schichtdicke von etwa 30 $\mu$m zwischen einer Kupferlage und einem $Si_3N_4$-Kerami-schicht angeordnet und anschließend der Anbindungsprozess vollzogen.

Die Lotsysteme aus den Proben AMB V1 bis AMB V5 setzten sich zusammen aus einer mittels PVD auf die $Si_3N_4$-Keramischicht aufgetragenen Titan-Aktivmetallschicht mit einer Dicke von 300 nm. Das Lotbasismaterial 16 entspricht dabei der Zusammensetzung aus der klassischen Lotpaste (ohne Titan), wie sie in den Referenzen 1 und 2 verwendet wurden und wurde jeweils als Lotfolie bereitgestellt.

Das Lotsystem wurde zwischen $Si_3N_4$-Keramischicht und Kupferlage angeordnet und anschließend angebunden.

Zum Bestimmen des Flächenwiderstands wurde die Kupferschicht sowie die Lotbasisschicht 14 mittels Ätzen wieder abgetragen. Als Resultat bleibt die Haftvermittlerschicht 13 an der Oberseite bzw. der Unterseite der Keramikschicht übrig.

Mittels einer XRF-Messung wurden die Bestanteile an den Oberseiten der zu vermessenden Proben bestimmt. Das Ergebnis zeigt die folgenden Anteile von Elementen an der Oberseite bzw. Unterseite der Keramikschicht mit der Haftvermittlerschicht in at%:

| Probe | Y | Si | Ti | Ag | Cu |
|---|---|---|---|---|---|
| Referenz 1 | 3.85 | 83.36 | 12.60 | 0.05 | 0.16 |
| Referenz 2 | 3.84 | 85.52 | 10.48 | 0.04 | 0.14 |
| AMB V 1 | 1.73 | 95.49 | 2.72 | 0.01 | 0.06 |
| AM B V 2 | 3.09 | 94.18 | 2.67 | 0.02 | 0.06 |
| AMB V 3 | 1.75 | 95.37 | 2.81 | 0.02 | 0.06 |
| AMB V 4 | 1.67 | 95.41 | 2.85 | 0.02 | 0.06 |
| AMB V 5 | 1.97 | 95.53 | 2.44 | 0.02 | 0.06 |

Der Tabelle ist zu entnehmen, dass die Silber- und Kupferanteile an der Oberseite und Unterseite der Probe verschwindend gering sind, so dass sie keinen nennenswerten Einfluss haben auf den Flächenwiderstand.

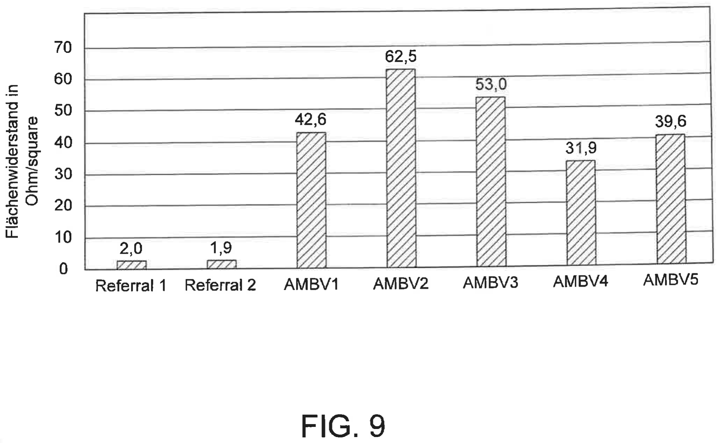

In **Figur 9** sind die Ergebnisse für die Flächenwiderstände, ermittelt nach dem oben beschriebenen Verfahren zusammengefasst. Zu erkennen ist, dass die Flächenwiderstände für die Proben AMB V1 bis AMB V5 mehr als 15 mal so groß sind im Vergleich zu den Flächenwiderstände für die Referenzen 1 und 2. Bei den Proben AMB V1 bis AMB V5 wurden zusätzlich Keramiken unterschiedlicher Hersteller sowie verschieden PVD-Anlagen verwendet. Die Flächenwiderstände spiegeln dabei den Anteil an Titan in der Bindungsschicht 12 bzw. der Haftvermittlerschicht 13 wieder, wie sie auch anhand der XRF-Messungen zu erkennen sind. Dieser reduzierte Titananteil hat maßgeblichen Einfluss auf die Ausbildung von spröden intermetallischen Phasen 42 in der Bindungsschicht 12, insbesondere auch in der Haftvermittlerschicht 13, die wiederum die Abzugsfestigkeit nachteilig beeinflussen. Der reduzierte Flächenwiderstand gibt somit zum Ausdruck, dass ein reduzierte Bildung von intermetallischen Phasen vorliegt, wenn der Flächenwiderstand größer als 5 Ohm/sq, bevorzugt größer als 10 Ohm/sq und besonders bevorzugt größer als 20 Ohm/sq ist.

Bezugszeichen:

| | |
|---|---|
| 1 | Trägersubstrat |
| 10 | Metallschicht |
| 12 | Bindungsschicht |
| 12' | weitere Bindungsschicht |
| 13 | Haftvermittlerschicht |
| 14 | Lotbasisschicht |
| 15 | Aktivmetallschicht |
| 16 | Lotbasismaterial |
| 20 | weitere Metallschicht |
| 30 | Isolationsschicht |
| 41 | spröde intermetallische Phasen |
| 42 | Einschlüsse |
| 45 | Messspitzen |
| s | Abstand |
| D | Dicke |
| HSE | Haupterstreckungsebene |
| S | Stapelrichtung |

**Patentansprüche**

1.  Verfahren zur Herstellung eines Trägersubstrat (1), insbesondere eines Metall-Keramik-Substrates, umfassend:

    - Bereitstellen mindestens einer Metallschicht (10) und eines Isolationselements (30), insbesondere eines Keramikelements (30), eines Glaselements, eines Glaskeramikelements und/oder eines hochtemperaturbeständiges Kunststoffelements, wobei sich die mindestens eine Metallschicht (10) und das Isolationselement (30) entlang einer Haupterstreckungsebene (HSE) erstrecken,
    - Anordnen der mindestens einen Metallschicht (10) und des Isolationselements (30) in einer senkrecht zur Haupterstreckungsebene (HSE) verlaufenden Stapelrichtung (S) übereinander, wobei zwischen der mindestens einen Metallschicht (10) und dem Isolationselement (30) eine Aktivmetallschicht (15) angeordnet wird, und
    - Anbinden der mindestens einen Metallschicht (10) an das Isolationselement (30) über die Aktivmetallschicht (15) unter Ausbildung einer Bindungsschicht (12) zwischen der mindestens einen Metallschicht (10) und dem Isolationselement (30), wobei die Bindungsschicht (12) entfernt wird, um das Trägersubstrat zu strukturieren, wobei das Strukturieren durch Laserlicht realisiert wird.

2.  Verfahren gemäß Anspruch 1, wobei ein Anteil an Verunreinigungen in der angeordneten Aktivmetallschicht (15) kleiner ist als 1 Gew.-%, bevorzugt kleiner als 0,7 Gew. -% und besonders bevorzugt kleiner als 0,5 Gew.-%.

3.  Verfahren gemäß einem der vorhergehenden Ansprüche, wobei ein physikalisches und/oder chemisches Gasphasenabscheiden oder Aufdampfen oder ein elektrochemisches Abscheiden derart durchgeführt wird, dass eine Dichte des auf dem Isolationselement angeordneten Aktivmetalls, die größer ist als 90 % einer theoretischen Dichte des Aktivmetalls, bevorzugt größer als 95 % der theoretischen Dichte des Aktivmetalls und besonders bevorzugt größer als 99% der theoretischen Dichte des Aktivmetalls.

4.  Verfahren gemäß einem der vorhergehenden Ansprüche, wobei eine Rauigkeit $R_a$ einer Oberfläche des Isolationselements (30) zumindest bereichsweise kleiner als 1,0 $\mu$m, bevorzugt kleiner als 0,7 $\mu$m und besonders bevorzugt kleiner als 0,5 $\mu$m ist

5.  Verfahren gemäß einem der vorhergehenden Ansprüche, wobei ein mehrschichtiges Lötsystem aus mindestens einer Lötschicht, vorzugsweise frei von schmelzpunkterniedrigenden Elementen, besonders bevorzugt aus einer phosphorfreien Lötschicht, und mindestens einer Aktivmetallschicht, vorgesehen wird.

6.  Verfahren gemäß einem der vorhergehenden Ansprüche wobei eine Haftvermittlerschicht (13) der Bindungsschicht (12) einen Flächenwiderstand aufweist der größer ist als 5 Ohm/sq, bevorzugt größer als 10 Ohm/sq und besonders bevorzugt größer als 20 Ohm/sq.

7.  Verfahren gemäß einem der vorhergehenden Ansprüche, wobei eine in Stapelrichtung (S) bemessene Dicke (D) der Bindungsschicht (12), gemittelt über mehrere Messpunkte innerhalb einer oder mehrere vorbestimmten Flächen (F), die parallel zur Haupterstreckungsebene (HSE) verläuft oder verlaufen, einen Wert annimmt, der kleiner als 20 $\mu$m, bevorzugt kleiner als 10 $\mu$m und besonders bevorzugt kleiner als 6 $\mu$m ist.

8.  Verfahren gemäß einem der vorhergehenden Ansprüche, wobei das Trägersubstrat (1) mindestens eine weitere Metallschicht (20) umfasst, die an dem Isolationselement (30) an einer der mindestens einen Metallschicht (10) gegenüberliegenden Seite angebunden ist, wobei im gefertigten Trägersubstrat (1) eine weitere Bindungsschicht (12') zwischen der mindestens einen weiteren Metallschicht (20) und dem Isolationselement (30) ausgebildet ist, wobei eine in Stapelrichtung (S) bemessene, aufsummierte Dicke der Bindungsschicht (12) und der weiteren Bindungsschicht (12'), gemittelt über mehrere Messpunkte innerhalb der Fläche (F) oder den Flächen (F), die parallel zur Haupterstreckungsebene (HSE) verläuft, einen Wert annimmt, der kleiner ist als 0,045 mm, bevorzugt kleiner als 0,0225 mm und besonders bevorzugt kleiner als 0,0135mm.

9.  Verfahren gemäß einem der vorhergehenden Ansprüche, wobei die Bindungsschicht (12) und/oder die weitere Bindungsschicht (12') eine silberreiche Schicht aus einem Lotmaterial und/oder einem Lotbasismaterial (16) aufweist.

10. Verfahren gemäß einem der vorhergehenden Ansprüche, wobei die Bindungsschicht (12) und/oder die weitere Bindungsschicht (12') eine ein Aktivmetall umfassende Haftvermittlungsschicht (13) ist.

**11.** Verfahren gemäß einem der vorhergehenden Ansprüche, wobei ein Anteil an Aktivmetall in der ein Aktivmetall umfassenden Haftvermittlerschicht (13) größer ist als 15 Gew.-%, bevorzugt größer als Gew.- 20 % und besonders bevorzugt größer als 25 Gew.- %.

**12.** Verfahren gemäß einem der vorhergehenden Ansprüche, wobei eine in Stapelrichtung (S) bemessene und aufsummierter Dicke (D) der Bindungsschicht (12) und der weiteren Bindungsschicht (12), gemittelt über mehrere Messpunkte innerhalb der Fläche (F), die parallel zur Haupterstreckungsebene (HSE) verläuft, einen Wert annimmt, der kleiner als 0,005 mm, bevorzugt kleiner als 0,001 mm und besonders bevorzugt kleiner als 0,0005 mm oder sogar 0,0003 mm ist.

**13.** Verfahren gemäß einem der vorhergehenden Ansprüch,e wobei eine Rauigkeit $R_a$ einer Oberfläche des Isolationselements (30) zumindest bereichsweise kleiner ist als 1,0 $\mu$m, bevorzugt kleiner als 0,7 $\mu$m und besonders bevorzugt kleiner als 0,5 $\mu$m.

**14.** Verfahren gemäß einem der vorhergehenden Ansprüche, wobei eine Rauigkeit $R_a$ einer Oberfläche des Isolationselements (30) zumindest bereichsweise größer ist als 1,0 $\mu$m, bevorzugt zwischen als 0,4 $\mu$m und 1,5 $\mu$m und besonders bevorzugt zwischen 0,75 und 1,25 $\mu$m.

**15.** Trägersubstrats (1) hergestellt mit einem Verfahren gemäß einem der vorhergehenden Ansprüche.

FIG. 1

10

15

30

15

20

FIG. 2

FIG. 3

FIG. 4

FIG. 5

FIG. 6A

FIG. 6B

FIG. 7

FIG. 8A

FIG. 8B

FIG. 9

EP 4 757 509 A2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102013104739 A1
- DE 19927046 B4
- DE 102009033029 A1
- DE 102013113734 B4
- JP 4325470 A
- DE 2013113734 A1